(19) Europäisches Patentamt
European Patent Office
Office européen des brevets

(11) EP 2 984 691 B1

(12) # EUROPÄISCHE PATENTSCHRIFT

(45) Veröffentlichungstag und Bekanntmachung des Hinweises auf die Patenterteilung:
**21.02.2018 Patentblatt 2018/08**

(21) Anmeldenummer: **14710804.7**

(22) Anmeldetag: **12.03.2014**

(51) Int Cl.:
***H01L 51/50*** *(2006.01)*

(86) Internationale Anmeldenummer:
**PCT/EP2014/000657**

(87) Internationale Veröffentlichungsnummer:
**WO 2014/166572 (16.10.2014 Gazette 2014/42)**

(54) **ORGANISCHE LICHTEMITTIERENDE VORRICHTUNG MIT VERZÖGERTER FLUORESZENZ**

ORGANIC LIGHT-EMITTING DEVICE HAVING DELAYED FLUORESCENCE

DISPOSITIF ÉMETTEUR DE LUMIÈRE ORGANIQUE À FLUORESCENCE RETARDÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.04.2013 EP 13001799**

(43) Veröffentlichungstag der Anmeldung:
**17.02.2016 Patentblatt 2016/07**

(73) Patentinhaber: **Merck Patent GmbH**
**64293 Darmstadt (DE)**

(72) Erfinder:
- **STOESSEL, Philipp**
  **60389 Frankfurt am Main (DE)**
- **PARHAM, Amir, Hossain**
  **60486 Frankfurt am Main (DE)**
- **PFLUMM, Christof**
  **64291 Darmstadt (DE)**
- **JATSCH, Anja**
  **60489 Frankfurt am Main (DE)**
- **KAISER, Joachim**
  **64289 Darmstadt (DE)**

(56) Entgegenhaltungen:
- **HIROYUKI TANAKA ET AL: "Efficient green thermally activated delayed fluorescence (TADF) from a phenoxazine-triphenyltriazine (PXZ-TRZ) derivative", CHEMICAL COMMUNICATIONS, Bd. 48, Nr. 93, 1. Januar 2012 (2012-01-01), Seite 11392, XP055115617, ISSN: 1359-7345, DOI: 10.1039/c2cc36237f -& Hiroyuki Tanaka ET AL: "Electronic Supplementary Information: Efficient green thermally activated delayed fluorescence (TADF) from a phenoxazine-triphenyltriazine (PXZ-TRZ) derivative Contents", Chemical Communications, 2012,48, 11392-11394, 11. Oktober 2012 (2012-10-11), XP055115819, DOI: 10.1039/C2CC36237F Gefunden im Internet: URL:http://www.rsc.org/suppdata/cc/c2/c2cc 36237f/c2cc36237f.pdf [gefunden am 2014-04-29]**
- **GÁBOR MÉHES ET AL: "Enhanced Electroluminescence Efficiency in a Spiro-Acridine Derivative through Thermally Activated Delayed Fluorescence", ANGEWANDTE CHEMIE INTERNATIONAL EDITION, Bd. 51, Nr. 45, 8. Oktober 2012 (2012-10-08), Seiten 11311-11315, XP055115730, ISSN: 1433-7851, DOI: 10.1002/anie.201206289 -& GÁBOR MÉHES ET AL: "Supporting Information: Enhanced Electroluminescence Efficiency in a Spiro-Acridine Derivative through Thermally Activated Delayed Fluorescence", ANGEWANDTE CHEMIE INTERNATIONAL EDITION, Bd. 51, Nr. 45, 8. Oktober 2012 (2012-10-08), Seiten 11311-11315, XP055115737, ISSN: 1433-7851, DOI: 10.1002/anie.201206289**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

(Forts. nächste Seite)

- **KENSUKE MASUI ET AL: "Analysis of exciton annihilation in high-efficiency sky-blue organic light-emitting diodes with thermally activated delayed fluorescence", ORGANIC ELECTRONICS, Bd. 14, Nr. 11, 30. Juli 2013 (2013-07-30) , Seiten 2721-2726, XP055115713, ISSN: 1566-1199, DOI: 10.1016/j.orgel.2013.07.010**

Bemerkungen:

Die Akte enthält technische Angaben, die nach dem Eingang der Anmeldung eingereicht wurden und die nicht in dieser Patentschrift enthalten sind.

## Beschreibung

Die vorliegende Anmeldung betrifft eine organische Elektrolumineszenzvorrichtung (OLED), welche eine emittierende Schicht enthaltend eine Verbindung mit einem geringen Unterschied zwischen den Energien des $S_1$- und des $T_1$-Zustands aufweist, und bei der für die HOMO- und LUMO-Energieniveaus der emittierenden Schicht und der Schichten zwischen Anode und emittierende Schicht bestimmte Bedingungen gelten.

Allgemein wird unter der Bezeichnung OLED eine elektronische Vorrichtung verstanden, welche mindestens ein organisches Material enthält und welche unter Anlegen von elektrischer Spannung Licht emittiert. Der grundsätzliche Aufbau und die Herstellung von OLEDs sind dem Fachmann allgemein bekannt und unter anderem in US 4539507, US 5151629, EP 0676461 und WO 98/27136 beschrieben.

Die Energien des $S_1$- und des $T_1$-Zustands einer Verbindung sowie die HOMO- und LUMO-Energieniveaus einer Verbindung sind definiert als diejenigen Energien, die für die betreffende Verbindung durch quantenchemische Rechnungen erhalten werden. Der $S_1$-Zustand ist dabei der energetisch am niedrigsten liegende angeregte Singulettzustand, und der $T_1$-Zustand ist der energetisch am niedrigsten liegende Triplettzustand. Wie die quantenchemischen Rechnungen genau durchgeführt werden, ist in den Ausführungsbeispielen detailliert beschrieben.

Unter dem HOMO-Energieniveau einer Schicht wird, wenn die Schicht aus einer einzelnen Verbindung besteht, das HOMO-Energieniveau dieser Verbindung verstanden. Unter dem HOMO-Energieniveau einer Schicht wird, wenn die Schicht aus zwei oder mehr unterschiedlichen Verbindungen besteht, das HOMO-Energieniveau derjenigen der zwei oder mehr unterschiedlichen Verbindungen verstanden, die das höchstliegende HOMO-Energieniveau hat. Dabei werden Verbindungen, die in sehr geringem Anteil vorliegen, nicht berücksichtigt. Bevorzugt werden nur Verbindungen berücksichtigt, die in einem Anteil von mindestens 1 Vol-% vorliegen, besonders bevorzugt mindestens 2 Vol-%, ganz besonders bevorzugt mindestens 3 Vol-%.

Unter dem LUMO-Energieniveau einer Schicht wird, wenn die Schicht aus einer einzelnen Verbindung besteht, das LUMO-Energieniveau dieser Verbindung verstanden. Unter dem LUMO-Energieniveau einer Schicht wird, wenn die Schicht aus zwei oder mehr unterschiedlichen Verbindungen besteht, das LUMO-Energieniveau derjenigen der zwei oder mehr unterschiedlichen Verbindungen verstanden, die das tiefstliegende LUMO-Energieniveau hat. Dabei werden Verbindungen, die in sehr geringem Anteil vorliegen, nicht berücksichtigt. Bevorzugt werden nur Verbindungen berücksichtigt, die in einem Anteil von mindestens 1 Vol-% vorliegen, besonders bevorzugt mindestens 2 Vol-%, ganz besonders bevorzugt mindestens 3 Vol-%.

Werte für HOMO- und LUMO-Energieniveaus sind definitionsgemäß negative Werte. Entsprechend ist unter "hohes Energieniveau" im Rahmen der vorliegenden Anmeldung ein relativ gesehen betragsmäßig geringer negativer Wert zu verstehen, und unter "niedriges Energieniveau" ein relativ gesehen betragsmäßig großer negativer Wert zu verstehen.

Bei der Entwicklung von neuartigen OLEDs besteht hohes Interesse an einer Verbesserung der Effizienz und der Betriebsspannung der Vorrichtungen. Weiterhin besteht Interesse an einer Verbesserung der Lebensdauer der Vorrichtungen, sowie an der generellen Verbesserung der Leistungsdaten beim Betrieb der OLED bei erhöhter Temperatur. Nochmals weiterhin besteht Interesse an der Bereitstellung von OLEDs, welche einfach und kostengünstig herzustellen sind, und welche inbesondere aus einfach herstellbaren und kostengünstigen Materialien aufgebaut werden können.

Im Stand der Technik ist bekannt, dass mit bestimmten rein organischen Verbindungen, welche nicht phosphoreszieren, sondern fluoreszieren, OLEDs mit sehr guten Effizienzen erhalten werden können. Beispielsweise ist in H. Uoyama et al., Nature 2012, 492, 234, offenbart, dass mit Carbazolyl-Cyanobenzolverbindungen als emittierende Verbindungen OLEDs mit externen Quanteneffizienzen erhalten werden können, die ähnlich gut oder besser als diejenigen sind, die mit phosphoreszierenden Emittern erhalten werden. Die verwendeten Carbazolyl-Cyanobenzolverbindungen zeigen thermisch aktivierte verzögerte Fluoreszenz (TADF), basierend auf einem geringen Energieunterschied zwischen $S_1$- und $T_1$-Zustand.

In der genannten Publikation wird 4,4-Bis-[N-(1-Naphthyl)-N-Phenylamino]-biphenyl (NPD) in der anodenseitig an die emittierende Schicht angrenzenden Schicht verwendet, und 4,4'-(Biscarbazol-9-yl)-biphenyl (CBP) als Matrixmaterial der emittierenden Schicht. In einem solchen Aufbau liegt eine Differenz zwischen dem HOMO-Energieniveau der emittierenden Schicht und der anodenseitig angrenzenden Schicht von 0.45 eV vor. Weiterhin werden in der genannten Publikation OLEDs mit zwei aufeinanderfolgenden Lochtransportschichten bestehend aus NPD und 1,3-Bis(9-carbazolyl)-benzol (mCP) und TAPC sowie darauf folgend einer emittierenden Schicht enthaltend 2,8-Bis-(diphenylphosphoryl)-dibenzo[b,d]thiophen (PPT) als Matrixmaterial offenbart. In diesem Fall beträgt die Differenz der HOMO-Energieniveaus zwischen der ersten und der zweiten Lochtransportschicht 0.58 eV, und zwischen der zweiten Lochtransportschicht und der Emissionsschicht 0.55 eV.

In Mehes et al., Angew. Chem. Int. Ed. 2012, 51, 11311, werden zwei aufeinanderfolgende Lochtransportschichten bestehend jeweils aus 1,3-Bis(9-carbazolyl)benzol (mCP) und TAPC und darauf folgend eine emittierende Schicht enthaltend Triphenyl-[4-(9-phenyl-9H-fluoren-9-yl)phenyl]silan (TPSi-F) als Matrixmaterial verwendet. In diesem

Fall beträgt die Differenz der HOMO-Energieniveaus zwischen der ersten und der zweiten Lochtransportschicht 0.73 eV und zwischen der zweiten Lochtransportschicht und der Emissionsschicht 0.33 eV.

Weitere OLEDs enthaltend Emitter, die thermisch aktivierte verzögerte Fluoreszenz zeigen, sind z. B. in Endo et al., Appl. Phys. Lett. 2011, 98, 083302, Nakagawa et al., Chem. Commun. 2012, 48, 9580, Tanaka et al., Chem. Comm. 2012, 11392, und Lee et al., Appl. Phys. Lett. 2012, 101, 093306/1 beschrieben. Allen Publikationen ist gemeinsam, dass wenigstens eine der HOMO-Differenzen gewählt aus den HOMO-Differenzen zwischen aufeinanderfolgenden Lochtransportschichten und der HOMO-Differenz zwischen der anodenseitig an die Emissionsschicht grenzenden Lochtransportschicht und der Emissionschicht deutlich über 0.4 eV liegt.

Die Weiterentwicklung von OLEDs für die Kommerzialisierung in Displays und Beleuchtungsanwendungen erfordert eine ständige Verbesserung der Leistungsdaten der Vorrichtungen, insbesondere der Betriebsspannung und der Effizienz.

Bei entsprechenden Untersuchungen wurde nun überraschend gefunden, dass mit OLEDs, welche eine emittierende Schicht enthaltend eine Verbindung mit einem geringen Unterschied zwischen den Energien des $S_1$- und des $T_1$-Zustands aufweisen, und bei denen für die relative Lage der HOMO- und LUMO-Energieniveaus der emittierenden Schicht und der Schichten zwischen Anode und emittierender Schicht bestimmte Bedingungen gelten, verbesserte Werte für die Effizienz und die Betriebsspannung erhalten werden. Weiterhin werden bevorzugt Verbesserungen bei der Lebensdauer erzielt.

Bevorzugt wird dabei ein Vorteil gegenüber Vorrichtungen gemäß dem Stand der Technik in mindestens einem der genannten Punkte erhalten, besonders bevorzugt in mehreren der genannten Punkte.

Gegenstand der Erfindung ist somit eine organische Elektrolumineszenzvorrichtung, enthaltend

- Anode,
- Kathode,
- mindestens eine emittierende Schicht, welche eine lumineszente organische Verbindung E enthält, die eine Differenz zwischen den Energien ihres $S_1$- und $T_1$-Zustands von nicht mehr als 0.15 eV aufweist, und
- 2, 3, 4 oder 5 zwischen Anoden-nächster emittierender Schicht EML und Anode angeordnete Schichten mit einer Dicke von jeweils mehr als 2 nm,

wobei für jede Schicht mit einer Dicke von mehr als 2 nm, die zwischen der Anode und der Schicht EML angeordnet ist, die folgende Bedingung gilt:

die Differenz D zwischen dem HOMO-Energieniveau der Schicht und dem HOMO-Energieniveau der kathodenseitig nächsten Schicht mit einer Dicke von mehr als 2 nm muss kleiner oder gleich 0.4 eV sein,
mit der Maßgabe, dass für Schichten, deren HOMO-Energieniveau einen Wert von weniger als -6.7 eV aufweist, das LUMO-Energieniveau für die genannte Bedingung an die Stelle des HOMO-Energieniveaus tritt wobei HOMO- und LUMO-Energieniveaus und Energien von $S_1$- und $T_1$-Zuständen von Verbindungen gemäß dem in Abschnitt 1) der Ausführungsbeispiele beschriebenen Verfahren zu bestimmen sind.

Unter einer organischen Verbindung im Sinne der vorliegenden Erfindung wird eine kohlenstoffhaltige Verbindung verstanden, die keine Metalle enthält. Bevorzugt ist eine organische Verbindung gemäß der vorliegenden Erfindung aus den Elementen C, H, D, B, Si, N, P, O, S, F, Cl, Br und I aufgebaut.

Unter einer lumineszenten Verbindung im Sinne der vorliegenden Erfindung wird eine Verbindung verstanden, die in der Lage ist, unter optischer Anregung in einer Umgebung, wie sie in der organischen Elektrolumineszenzvorrichtung vorliegt, bei Raumtemperatur Licht zu emittieren.

Unter Anoden-nächster emittierender Schicht wird diejenige emittierende Schicht verstanden, welche von der Anode aus gesehen am nächsten liegt.

Unter der Differenz D zwischen dem HOMO-Energieniveau einer Schicht und dem HOMO-Energieniveau der kathodenseitig nächsten Schicht gilt dabei, wenn die Schicht als L(i) bezeichnet ist und die kathodenseitig nächste Schicht als L(i+1), und das HOMO-Energieniveau der Schicht L(i) als HOMO(L(i)) bezeichnet ist, und das HOMO-Energieniveau der Schicht L(i+1) als HOMO(L(i+1)):

$$D = \mathrm{HOMO}(L(i)) - \mathrm{HOMO}(L(i+1)) \qquad \text{Gleichung (1)}$$

Die Differenz D kann erfindungsgemäß auch negativ werden.

Die Berechnung von D wird entsprechend durchgeführt, wenn das LUMO-Energieniveau für Schichten, deren

HOMO-Energieniveau einen Wert von weniger als -6.7 eV aufweist, an die Stelle des HOMO-Energieniveaus tritt. Dies kann für beide benachbarten Schichten der Fall sein, oder es kann für eine der beiden benachbarten Schichten der Fall sein.

Folgende Fälle können dann auftreten:

$$D = LUMO(L(i)) - HOMO(L(i+1)) \quad \text{Gleichung (2),}$$

wenn L(i) ein HOMO-Energieniveau mit einem Wert von weniger als -6.7 eV aufweist, L(i+1) jedoch nicht;

$$D = HOMO(L(i)) - LUMO(L(i+1)) \quad \text{Gleichung (3),}$$

wenn L(i+1) ein HOMO-Energieniveau mit einem Wert von weniger als -6.7 eV aufweist, L(i) jedoch nicht;

$$D = LUMO(L(i)) - LUMO(L(i+1)) \quad \text{Gleichung (4),}$$

wenn L(i) und L(i+1) ein HOMO-Energieniveau mit einem Wert von weniger als -6.7 eV aufweisen.

Bevorzugt gilt die Maßgabe, dass für bestimmte Schichten das LUMO-Energieniveau an die Stelle des HOMO-Energieniveaus tritt, für Schichten mit einem HOMO-Energieniveau von weniger als -6.9 eV, besonders bevorzugt für Schichten mit einem HOMO-Energieniveau von weniger als -7.2 eV.

Gemäß einer Variante der Erfindung gilt die oben erläuterte Maßgabe, dass für bestimmte Schichten das LUMO-Energieniveau an die Stelle des HOMO-Energieniveaus tritt, nicht, und es ist grundsätzlich das HOMO-Energieniveau heranzuziehen.

Bevorzugt gilt weiterhin für jede Schicht mit einer Dicke von mehr als 2 nm, die zwischen der Anode und der Schicht EML angeordnet ist, dass die Differenz D zwischen dem HOMO-Energieniveau der Schicht und dem HOMO-Energieniveau der kathodenseitig nächsten Schicht mit einer Dicke von mehr als 2 nm kleiner oder gleich 0.38 eV ist, besonders bevorzugt kleiner oder gleich 0.35 eV, und ganz besonders bevorzugt kleiner oder gleich 0.3 eV.

Erfindungsgemäß gilt die Bedingung zur Differenz der HOMO- bzw. LUMO-Energieniveaus benachbarter Schichten zwischen Anode und Schicht EML für Schichten mit einer Dicke von mindestens 2 nm. Bevorzugt gelten sie für Schichten mit einer Dicke von mehr als 1.5 nm, besonders bevorzugt für Schichten mit einer Dicke von mehr als 1 nm, ganz besonders bevorzugt für Schichten mit einer Dicke von mehr als 0.5 nm, und am stärksten bevorzugt für alle Schichten.

Die erfindungsgemäße Vorrichtung enthält bevorzugt zusätzlich zu Anode, Kathode, emittierender Schicht, und mindestens einer zwischen Anode und emittierender Schicht angeordneten Schicht noch zusätzliche Schichten. Diese Schichten sind bevorzugt gewählt aus weiteren zwischen Anode und emittierender Schicht angeordneten Schichten und weiteren zwischen emittierender Schicht und Kathode angeordneten Schichten.

Bevorzugt umfasst die erfindungsgemäße Vorrichtung genau eine emittierende Schicht.

Bevorzugt sind die Schichten der erfindungsgemäßen Vorrichtung im durch Anode und Kathode gebildeten Zwischenraum angeordnet.

Dabei gelten Anode und Kathode nicht als Schichten der organischen Elektrolumineszenzvorrichtung im Sinne der vorliegenden Anmeldung.

Weitere Schichten, die in der erfindungsgemäßen Vorrichtung vorhanden sein können, sind bevorzugt gewählt aus Lochinjektionsschichten, Lochtransportschichten, Lochblockierschichten, Elektronentransportschichten, Elektroneninjektionsschichten, Elektronenblockierschichten, Excitonenblockierschichten, Zwischenschichten (Interlayers), Ladungserzeugungsschichten (Charge-Generation Layers) (IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer) und/oder organischen oder anorganischen p/n-Übergängen. Die Funktion und bevorzugte Anordnung dieser Schichten sind dem Fachmann bekannt. Weiterhin sind dem Fachmann mögliche Verbindungen zur Verwendung in den jeweiligen Schichten bekannt.

Unter Lochtransportschicht wird im Rahmen der vorliegenden Anmeldung eine Schicht verstanden, welche unter anderem lochleitende Eigenschaften hat und zwischen Anode und der Schicht EML angeordnet ist.

Als Lochinjektionsschicht gilt eine spezielle Ausführungsform einer Lochtransportschicht, die bei Vorliegen von mehr als einer zwischen Anode und der Schicht EML vorliegenden Schichten die Anoden-nächste von diesen Schichten ist.

Als Elektronenblockierschicht gilt eine spezielle Ausführungsform einer Lochtransportschicht, die bei Vorliegen

von mehr als einer zwischen Anode und Schicht EML vorliegenden Schichten diejenige Schicht ist, die direkt anodenseitig an die Schicht EML angrenzt und die elektronenblockierende Eigenschaften hat.

Unter Elektronentransportschicht wird eine Schicht verstanden, die unter anderem elektronenleitende Eigenschaften hat, und die zwischen Kathoden-nächster emittierender Schicht und Kathode angeordnet ist.

Als Elektroneninjektionsschicht gilt eine spezielle Ausführungsform einer Elektronentransportschicht, die bei Vorliegen von mehr als einer zwischen Kathode und Kathoden-nächster emittierender Schicht vorliegenden Schichten die Kathoden-nächste von diesen Schichten ist.

Als Lochblockierschicht gilt eine spezielle Ausführungsform einer Elektronentransportschicht, die bei Vorliegen von mehr als einer zwischen Kathode und Kathoden-nächster emittierender Schicht vorliegenden Schichten diejenige Schicht ist, die direkt kathodenseitig an die kathoden-nächste emittierende Schicht angrenzt und die lochblockierende Eigenschaften hat.

Die Schichten der erfindungsgemäßen Vorrichtung enthalten bevorzugt eine oder mehrere organische Verbindungen. Besonders bevorzugt sind sie im Wesentlichen aus organischen Verbindungen aufgebaut, sind also organische Schichten.

In den Schichten können alle Materialien verwendet werden, wie sie üblicherweise gemäß dem Stand der Technik in den betreffenden Schichten eingesetzt werden.

Die Schichten der erfindungsgemäßen Vorrichtung haben bevorzugt eine Dicke von 1 bis 200 nm, bevorzugt von 3 bis 150 nm, besonders bevorzugt von 4 bis 120 nm. Dabei gelten, wie oben erwähnt, Anode und Kathode nicht als Schichten der Vorrichtung.

Es ist bevorzugt, dass die erfindungsgemäße Vorrichtung keine Schichten mit einer Dicke von weniger als 3 nm aufweist, besonders bevorzugt keine mit einer Dicke von weniger als 2 nm, und ganz besonders bevorzugt keine mit einer Dicke von weniger als 1 nm. Weiterhin ist es bevorzugt, dass, wenn eine oder mehrere Schichten mit einer Dicke von weniger als 3 nm, bevorzugt weniger als 2 nm, besonders bevorzugt weniger als 1 nm, in der erfindungsgemäßen Vorrichtung vorliegen, diese nicht direkt aufeinander folgend vorliegen, sondern durch mindestens eine Schicht mit einer größeren Dicke getrennt sind.

Die Abfolge der Schichten der erfindungsgemäßen Vorrichtung ist bevorzugt wie folgt:

- Anode-
- Lochtransportschicht-
- optional weitere Lochtransportschichten-
- emittierende Schicht-
- Elektronentransportschicht-
- optional weitere Elektronentransportschichten-
- optional Elektroneninjektionsschicht-
- Kathode-.

Es können zusätzlich weitere Schichten in der erfindungsgemäßen Vorrichtung vorhanden sein.

Die emittierende Schicht, welche die lumineszente organische Verbindung E enthält, ist bevorzugt die Anoden-nächste emittierende Schicht EML.

Weiterhin weist die lumineszente Verbindung E bevorzugt eine Lumineszenzquanteneffizienz von mindestens 40 % auf, besonders bevorzugt von mindestens 50 %, ganz besonders bevorzugt von mindestens 60 % und insbesondere bevorzugt von mindestens 70 %. Dabei wird die Lumineszenzquanteneffizienz bestimmt in einer Schicht in Mischung mit dem Matrixmaterial, analog wie die Schicht in der organischen Elektrolumineszenzvorrichtung eingesetzt werden soll. Wie die Bestimmung der Lumineszenzquantenausbeute im Sinne der vorliegenden Erfindung durchgeführt wird, ist in den Ausführungsbeispielen ausführlich beschrieben.

Weiterhin ist es bevorzugt, dass die Verbindung E eine Abklingzeit der Lumineszenz von weniger als 50 $\mu$s aufweist, besonders bevorzugt eine Abklingzeit von weniger als 20 $\mu$s aufweist, ganz besonders bevorzugt eine Abklingzeit von weniger als 10 $\mu$s aufweist und am stärksten bevorzugt eine Abklingzeit von weniger als 8 $\mu$s aufweist. Wie die Abklingzeit gemäß der vorliegenden Anmeldung bestimmt wird, ist in den Ausführungsbeispielen beschrieben.

Erfindungsgemäß weist die Verbindung E eine Differenz zwischen den Energien ihres $S_1$- und $T_1$-Zustands von nicht mehr als 0.15 eV auf. Bevorzugt beträgt die Differenz nicht mehr als 0.10 eV, besonders bevorzugt nicht mehr als 0.08 eV, und ganz besonders bevorzugt nicht mehr als 0.05 eV.

Bei der Verbindung E handelt es sich bevorzugt um eine aromatische Verbindung, die sowohl Donor- als auch auch Akzeptorsubstituenten aufweist. Dabei ist es bevorzugt, dass das LUMO und das HOMO der Verbindung räumlich nur geringfügig überlappen.

Was unter Donor- bzw. Akzeptorsubstituenten verstanden wird, ist dem Fachmann prinzipiell bekannt. Geeignete Donorsubstituenten sind insbesondere Diaryl- bzw. -heteroarylaminogruppen sowie Carbazolgruppen bzw. Carbazolderivate, die jeweils bevorzugt über N an die aromatische Verbindung gebunden sind. Dabei können diese Gruppen

auch weiter substituiert sein. Geeignete Akzeptorsubstituenten sind insbesondere Cyanogruppen, aber auch beispielsweise elektronenarme Heteroarylgruppen, die auch weiter substituiert sein können.

Beispiele für Verbindungen E sind in der folgenden Tabelle aufgeführt.

| | | |
|---|---|---|
| 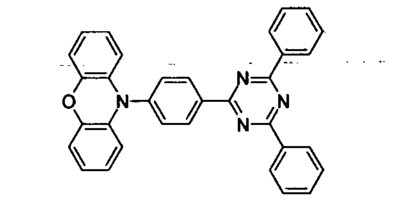 | 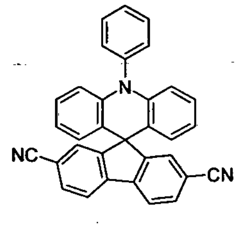 | 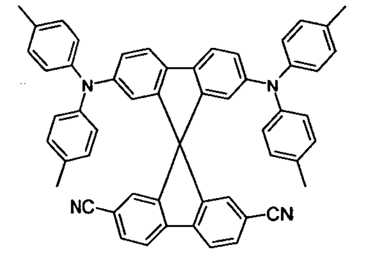 |
| 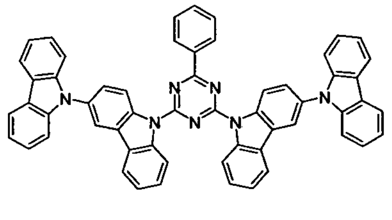 | 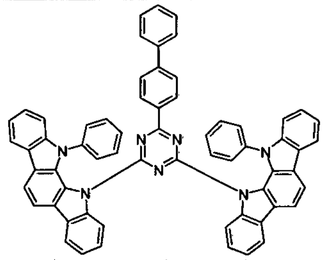 | 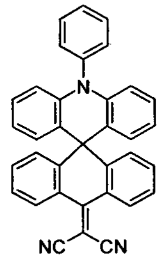 |
| 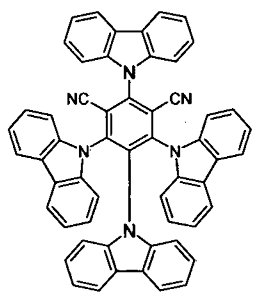 | 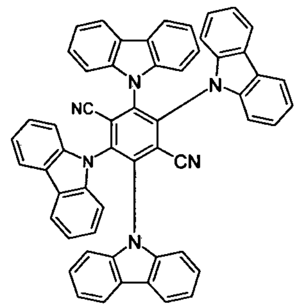 | 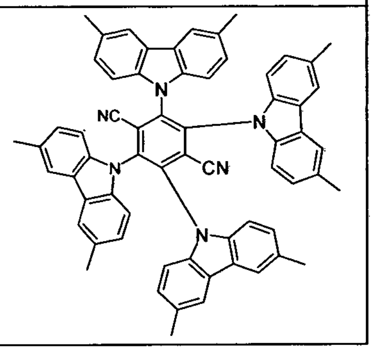 |

| | | |
|---|---|---|
| 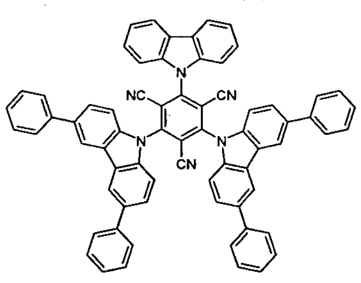 | 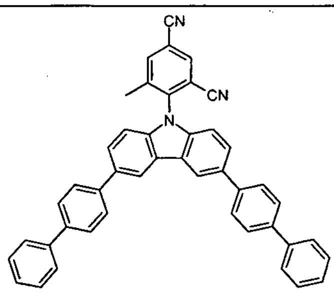 | 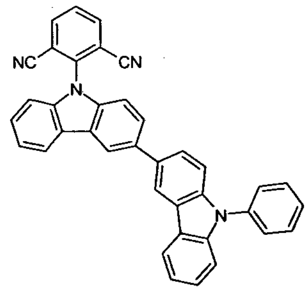 |
| 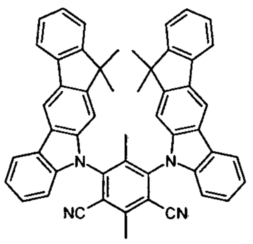 | 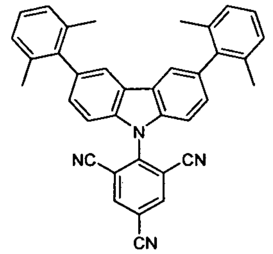 | 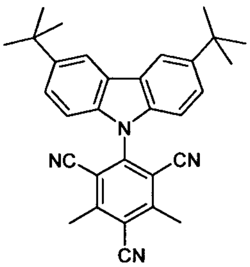 |
| 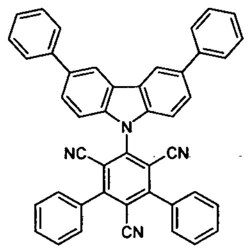 | 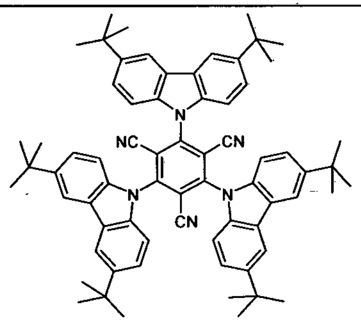 | 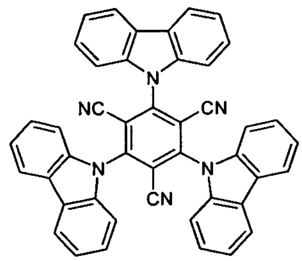 |

Die emittierende Schicht, welche die Verbindung E enthält, umfasst bevorzugt zusätzlich ein oder mehrere Matrixmaterialien, und die Verbindung E ist die emittierende Verbindung.

Unter einem Matrixmaterial wird in einem System enthaltend zwei oder mehr Materialien diejenige Komponente verstanden, deren Anteil in der Mischung der größere ist. Entsprechend wird unter einem Dotanden in einem System enthaltend zwei oder mehr Materialien diejenige Komponente verstanden, deren Anteil in der Mischung der kleinere ist. Typischerweise liegen in emittierenden Schichten die emittierenden Verbindungen als Dotanden vor, und die nicht emittierenden Verbindungen liegen als Matrixmaterialien vor.

Bevorzugt liegt die Verbindung E in der emittierenden Schicht in einem Anteil von 1 bis 6 Vol-%, besonders bevorzugt von 3 bis 6 Vol-% vor. Bevorzugt liegen in diesem Fall außer der Verbindung E als weitere Verbindungen nur eine oder mehrere Matrixverbindungen in der emittierenden Schicht vor, so dass diese den restlichen Anteil ausmachen.

Es ist bevorzugt, wenn für LUMO(E), also das LUMO-Energieniveau der Verbindung E, und HOMO(Matrix), also das HOMO-Energieniveau des Matrixmaterials, gilt:

$$\text{LUMO(E)} - \text{HOMO(Matrix)} > S_1(\text{E}) - 0.4\ \text{eV};$$

besonders bevorzugt:

$$\text{LUMO(E)} - \text{HOMO(Matrix)} > S_1(\text{E}) - 0.3\ \text{eV};$$

und ganz besonders bevorzugt:

$$\text{LUMO(E)} - \text{HOMO(Matrix)} > S_1(\text{E}) - 0.2\ \text{eV}.$$

Dabei ist $S_1$(E) die Energie des ersten angeregten Singulettzustands der Verbindung E.

Es ist weiterhin bevorzugt, dass die Energie des $T_1$-Zustands des Matrixmaterials der emittierenden Schicht, im Folgenden bezeichnet als $T_1$(Matrix), höchstens 0.1 eV niedriger ist als die Energie des $T_1$-Zustands der Verbindung E, im Folgenden bezeichnet als $T_1$(E). Besonders bevorzugt ist $T_1$(Matrix) ≥ $T_1$(E). Ganz besonders bevorzugt gilt: $T_1$(Matrix) - $T_1$(E) ≥ 0.1 eV, am stärksten bevorzugt $T_1$(Matrix) - $T_1$(E) ≥ 0.2 eV.

Beispiele für geeignete Matrixmaterialien in der emittierenden Schicht sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, oder verbrückte Carbazolderivate, z. B. gemäß US 2009/0136779, WO 2010/050778, WO 2011/042107 oder WO 2011/088877.

Bevorzugt zur Verwendung als Matrixmaterialien in der emittierenden Schicht sind elektronentransportierende organische Verbindungen. Besonders bevorzugt sind elektronentransportierende organische Verbindungen, die ein LUMO-Energieniveau von höchstens -2.50 eV aufweisen, besonders bevorzugt höchstens -2.60 eV, ganz besonders bevorzugt höchstens -2.65 eV, und am stärksten bevorzugt höchstens -2.70 eV.

Besonders bevorzugte Matrixmaterialien in der emittierenden Schicht sind ausgewählt aus den Stoffklassen der Triazine, der Pyrimidine, der Lactame, der Metallkomplexe, insbesondere der Be-, Zn- bzw. Al-Komplexe, der aromatischen Ketone, der aromatischen Phosphinoxide, der Azaphosphole, der Azaborole, welche mit mindestens einem elektronenleitenden Substituenten substituiert sind, der Chinoxaline, der Chinoline und der Isochinoline.

Die erfindungsgemäße Vorrichtung enthält 2, 3, 4 oder 5 zwischen Anoden-nächster emittierender Schicht EML und Anode angeordnete Schichten mit einer Dicke von mehr als 2 nm, bevorzugt genau 2, 3 oder 4 solcher Schichten.

Es ist bevorzugt, dass die Energie des $T_1$-Zustands der direkt anodenseitig an die emittierende Schicht enthaltend die Verbindung E angrenzende Schicht, im Folgenden bezeichnet als $T_1$(EBL), höchstens um 0.1 eV niedriger ist als die Energie des $T_1$-Zustands der Verbindung E, im Folgenden bezeichnet als $T_1$(E). Besonders bevorzugt ist $T_1$(EBL) ≥ $T_1$(E). Ganz besonders bevorzugt gilt: $T_1$(EBL) - $T_1$(E) ≥ 0.1 eV, am stärksten bevorzugt $T_1$(EBL) - $T_1$(E) ≥ 0.2 eV.

Es ist weiterhin bevorzugt, dass das LUMO-Energieniveau der Schicht, die anodenseitig an die Schicht EML angrenzt, mindestens um 0.2 eV größer ist als das LUMO-Energieniveau der Schicht EML, und bevorzugt mindestens um 0.3 eV größer ist.

Es ist bevorzugt, dass mindestens eine der zwischen der Schicht EML und der Anode angeordneten Schichten mindestens eine Triarylamino-Verbindung enthält. Bevorzugt enthalten mehrere der zwischen der Schicht EML und der Anode angeordneten Schichten mindestens eine Triarylamino-Verbindung. Unter einer Triarylamino-Verbindung gemäß der vorliegenden Anmeldung wird eine Verbindung verstanden, in der drei Aryloder Heteroarylgruppen an ein gemeinsames Stickstoffatom gebunden sind. Die Aryl- oder Heteroarylgruppen, die an das gemeinsame Stickstoffatom binden, können über divalente Gruppen oder Einfachbindungen miteinander verbunden sein. Bevorzugt sind sie nicht miteinander verbunden. Die Triarylamino-Verbindung kann neben der genannten Struktureinheit beliebige weitere Gruppen und Substituenten aufweisen.

Bevorzugt enthält mindestens eine der zwischen der Schicht EML und der Anode angeordneten Schichten mindestens eine Triarylamino-Verbindung, die nicht mehr als eine Aminogruppe aufweist. Bevorzugt enthalten mehrere der zwischen der Schicht EML und der Anode angeordneten Schichten mindestens eine Triarylamino-Verbindung, die nicht mehr als eine Aminogruppe aufweist.

Bevorzugt ist die Triarylamino-Verbindung ein kleines organisches Molekül und weist ein Molekulargewicht von weniger als 2000 Da, bevorzugt weniger als 1500 Da und besonders bevorzugt weniger als 1000 Da auf.

Eine Arylgruppe im Sinne dieser Erfindung enthält 6 bis 60 aromatische Ringatome; eine Heteroarylgruppe im Sinne dieser Erfindung enthält 5 bis 60 aromatische Ringatome, von denen mindestens eines ein Heteroatom darstellt. Die Heteroatome sind bevorzugt ausgewählt aus N, O und S. Dies stellt die grundlegende Definition dar.

Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin oder Thiophen, oder ein kondensierter (annellierter) aromatischer bzw. heteroaromatischer Polycyclus, beispielsweise Naphthalin, Phenanthren, Chinolin oder Carbazol verstanden. Ein kondensierter (annellierter) aromatischer bzw. heteroaromatischer Polycyclus besteht im Sinne der vorliegenden Anmeldung aus zwei oder mehr miteinander kondensierten einfachen aromatischen bzw. heteroaromatischen Cyclen.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen

verstanden, welche abgeleitet sind von Benzol, Naphthalin, Anthracen, Phenanthren, Pyren, Dihydropyren, Chrysen, Perylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt enthält mindestens eine der zwischen der Schicht EML und der Anode angeordneten Schichten mindestens eine Verbindung der Formel (I)

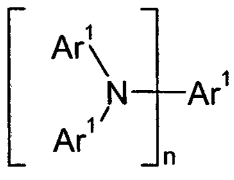

Formel (I),

wobei gilt:

$Ar^1$ ist bei jedem Auftreten gleich oder verschieden ein aromatisches oder heteroaromatisches Ringsystem mit 5 bis 30 aromatischen Ringatomen, das mit einem oder mehreren Resten $R^1$ substituiert sein kann; und

$R^1$ ist bei jedem Auftreten gleich oder verschieden H, D, F, $C(=O)R^2$, CN, $Si(R^2)_3$, $P(=O)(R^2)_2$, $S(=O)R^2$, $S(=O)_2R^2$, eine geradkettige Alkyl- oder Alkoxygruppe mit 1 bis 20 C-Atomen oder eine verzweigte oder cyclische Alkyl- oder Alkoxygruppe mit 3 bis 20 C-Atomen oder eine Alkenyl- oder Alkinylgruppe mit 2 bis 20 C-Atomen, wobei die oben genannten Gruppen jeweils mit einem oder mehreren Resten $R^2$ substituiert sein können und wobei eine oder mehrere $CH_2$-Gruppen in den oben genannten Gruppen durch $-R^2C=CR^2-$, -C=C-, $Si(R^2)_2$, C=O, C=S, $C=NR^2$, -C(=O)O-, $-C(=O)NR^2-$, $P(=O)(R^2)$, -O-, -S-, SO oder $SO_2$ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste $R^2$ substituiert sein kann, oder eine Aryloxy- oder Heteroaryloxygruppe mit 5 bis 30 aromatischen Ringatomen, die durch einen oder mehrere Reste $R^2$ substituiert sein kann, wobei zwei oder mehr Reste $R^1$ miteinander verknüpft sein können und einen Ring bilden können;

$R^2$ ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten $R^2$ miteinander verknüpft sein und einen Ring bilden;

n ist 1, 2, 3 oder 4.

Ein aromatisches Ringsystem im Sinne dieser Erfindung enthält 6 bis 60 C-Atome im Ringsystem. Ein heteroaromatisches Ringsystem im Sinne dieser Erfindung enthält 5 bis 60 aromatische Ringatome, von denen mindestens eines ein Heteroatom darstellt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein $sp^3$hybridisiertes C-, Si-, N- oder O-Atom, ein $sp^2$-hybridisiertes C- oder N-Atom oder ein sp-hybridisiertes C-Atom, verbunden sein können. So sollen beispielsweise auch Systeme wie 9,9'-Spirobifluoren, 9,9'-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl- oder Alkinylgruppe oder durch eine Silylgruppe verbunden sind. Weiterhin werden auch Systeme, in denen zwei oder mehr Aryl- oder Heteroarylgruppen über Einfachbindungen miteinander verknüpft sind, als aromatische oder heteroaromatische Ringsysteme im Sinne dieser Erfindung verstanden, wie beispielsweise Systeme wie Biphenyl, Terphenyl oder Diphenyltriazin.

Unter einem aromatischen oder heteroaromatischen Ringsystem mit 5 - 60 aromatischen Ringatomen, welches noch jeweils mit Resten wie oben definiert substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Naphthacen, Pentacen, Benzpyren, Biphenyl, Biphenylen, Terphenyl, Terphenylen, Quaterphenyl, Fluoren, Spirobifluoren, Dihydrophenanthren, Dihydropyren, Tetrahydropyren, cisoder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Kombinationen dieser Gruppen.

Im Rahmen der vorliegenden Erfindung werden unter einer geradkettigen Alkylgruppe mit 1 bis 40 C-Atomen bzw. einer verzweigten oder cyclischen Alkylgruppe mit 3 bis 40 C-Atomen bzw. einer Alkenyl- oder Alkinylgruppe mit 2 bis 40 C-Atomen, in der auch einzelne H-Atome oder $CH_2$-Gruppen durch die oben bei der Definition der Reste genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, neoPentyl, n-Hexyl, Cyclohexyl, neo-Hexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer Alkoxy- oder Thioalkylgruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy, 2,2,2-Trifluorethoxy, Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden.

Unter der Bildung eines Rings zwischen zwei Substituenten wird dabei bevorzugt die Bildung eines aromatischen, heteroaromatischen, aliphatischen oder heteroaliphatischen Rings verstanden. Der Ring ist bevorzugt fünf- bis zehngliedrig, besonders bevorzugt fünf- bis sechsgliedig.

$Ar^1$ ist bevorzugt ein aromatisches Ringsystem mit 6 bis 30 aromatischen Ringatomen, das mit einem oder mehreren Resten $R^1$ substituiert sein kann. Besonders bevorzugt enthält $Ar^1$ eine mit $R^1$ substituierte oder unsubstituierte Gruppe gewählt aus Fluoren, Indenofluoren, Spirobifluoren, Phenyl, Biphenyl, Terphenyl oder Naphthyl.

Weiterhin bevorzugt umfasst $Ar^1$ keine kondensierte Arylgruppe mit mehr als 14 aromatischen Ringatomen, besonders bevorzugt keine kondensierte Arylgruppe mit mehr als 10 aromatischen Ringatomen.

Weiterhin bevorzugt umfasst $Ar^1$ keine kondensierte Heteroarylgruppe mit mehr als 14 aromatischen Ringatomen, besonders bevorzugt keine kondensierte Heteroarylgruppe mit mehr als 10 aromatischen Ringatomen.

Weiterhin gelten die unten genannten Bevorzugungen betreffend $Ar^1$.

Bevorzugt ist der Index n gleich 1 oder 2, besonders bevorzugt gleich 1.

Bevorzugt enthält mindestens eine der zwischen der Schicht EML und der Anode angeordneten Schichten mindestens eine Verbindung der Formeln (I-1) bis (I-6)

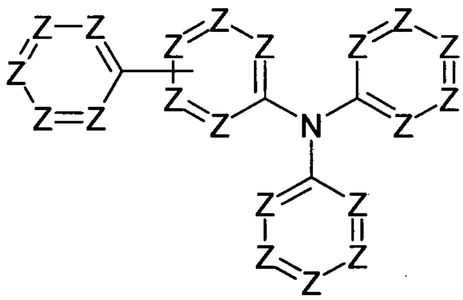

Formel (I-1)

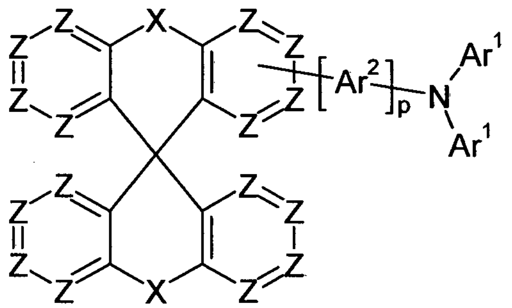

Formel (I-2)

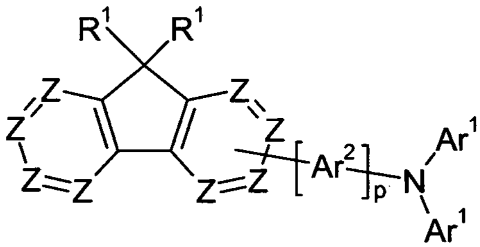

Formel (I-3)

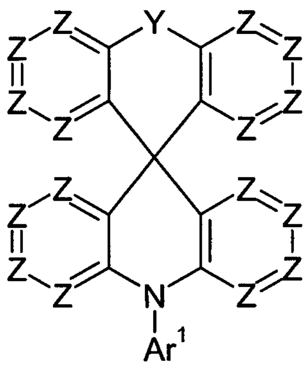

Formel (I-4)

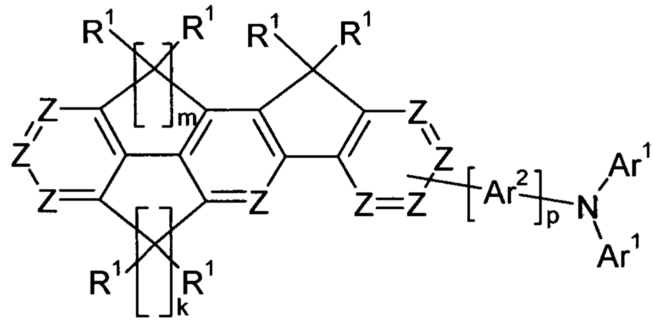

Formel (I-5)

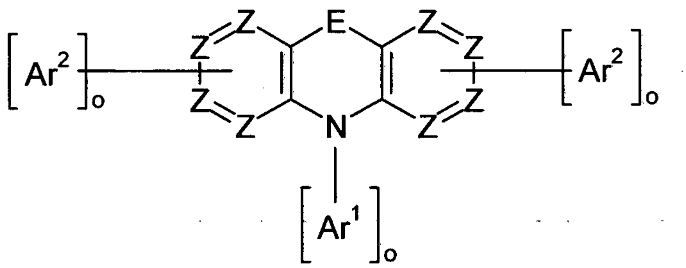

Formel (I-6)

wobei gilt:

Z ist bei jedem Auftreten gleich oder verschieden N oder $CR^1$, wobei Z gleich C ist, wenn ein Substituent gebunden ist;

X ist bei jedem Auftreten gleich oder verschieden eine Einfachbindung, O, S, $BR^1$, $C(R^1)_2$, $Si(R^1)_2$, $NR^1$, $PR^1$, $C(R^1)_2$-$C(R^1)_2$, oder $CR^1$=$CR^1$;

Y ist eine Einfachbindung, O, S, $BR^1$, $C(R^1)_2$, $Si(R^1)_2$, $NR^1$, $PR^1$, $C(R^1)_2$-$C(R^1)_2$, oder $CR^1$=$CR^1$;

E ist O, S, $BR^1$, $C(R^1)_2$, $Si(R^1)_2$, $NR^1$, $PR^1$, $C(R^1)_2$-$C(R^1)_2$, oder $CR^1$=$CR^1$;

$Ar^1$ ist definiert wie oben;

$Ar^2$ ist ein aromatisches oder heteroaromatisches Ringsystem mit 6 bis 18 aromatischen Ringatomen, das mit einem oder mehreren Resten $R^1$ substituiert sein kann;

$R^1$ ist definiert wie oben;

o ist bei jedem Auftreten gleich oder verschieden 0 oder 1, wobei die Summe aller Indices o mindestens gleich 1 ist;

p ist gleich 0 oder 1;

k, m sind gleich oder verschieden 0 oder 1, wobei die Summe aller Indices k und m gleich 1 oder 2 ist.

Für die oben genannten Formeln (I-1) bis (I-6) gilt bevorzugt, dass nicht mehr als drei Gruppen Z in einem Ring gleich N sind. Es ist allgemein bevorzugt, dass Z gleich $CR^1$ ist.

Die Gruppe X ist bei jedem Auftreten bevorzugt gleich oder verschieden gewählt aus einer Einfachbindung, $C(R^1)_2$, O und S, besonders bevorzugt ist sie eine Einfachbindung.

Die Gruppe Y ist bevorzugt gewählt aus O und $C(R)_2$, besonders bevorzugt ist sie O.

Die Gruppe E ist bevorzugt gewählt aus $C(R^1)_2$, O und S, besonders bevorzugt ist sie $C(R^1)_2$.

Die Gruppe $Ar^1$ ist in den oben genannten Formeln bevorzugt bei jedem Auftreten gleich oder verschieden

gewählt aus aromatischen oder heteroaromatischen Ringsystemen mit 6 bis 30 aromatischen Ringatomen, die mit einem oder mehreren Resten $R^1$ substituiert sein können. Besonders bevorzugt ist $Ar^1$ in den oben genannten Formeln bei jedem Auftreten gleich oder verschieden gewählt aus Aryl- oder Heteroarylgruppen mit 6 bis 18 aromatischen Ringatomen, die mit einem oder mehreren Resten $R^1$ substituiert sein können.

Beispiele für Verbindungen, die in den zwischen Anode und Schicht EML vorliegenden Schichten eingesetzt werden können, sind im Folgenden aufgeführt.

| | | |
|---|---|---|
| 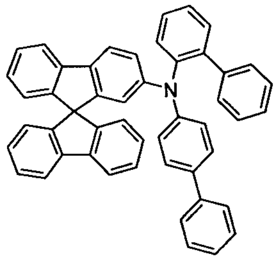 | 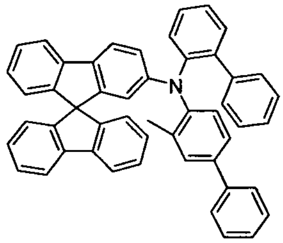 | 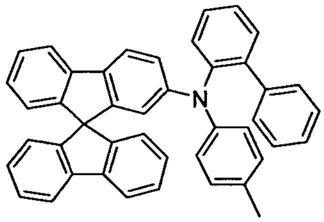 |
| 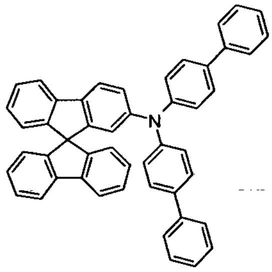 | 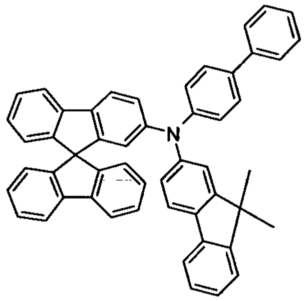 | 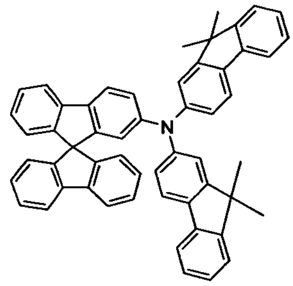 |
| 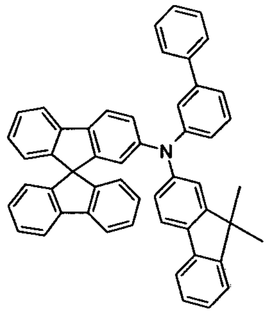 | 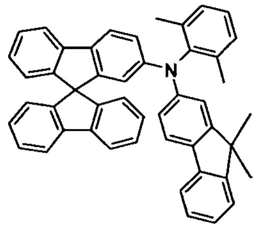 | 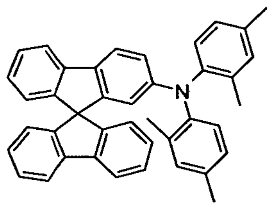 |
| 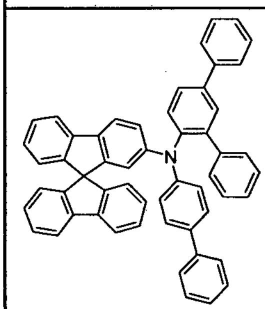 | 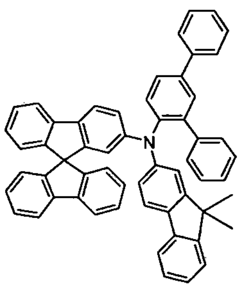 | 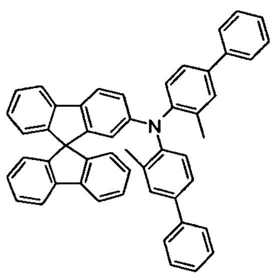 |

| | | |
|---|---|---|
| 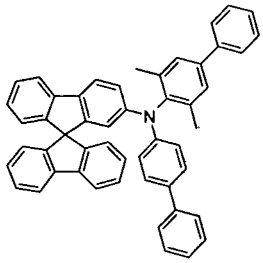 | 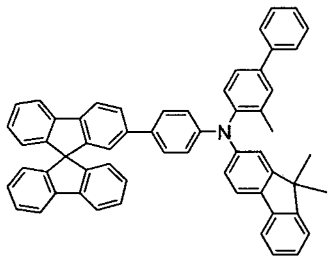 | 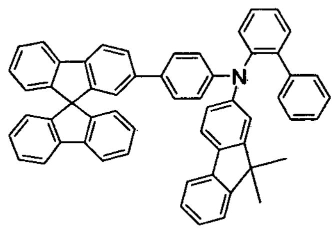 |
| 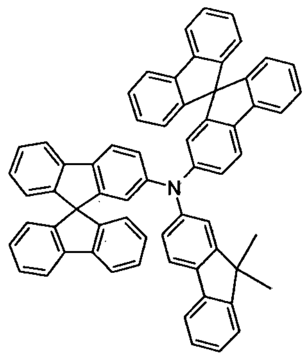 | 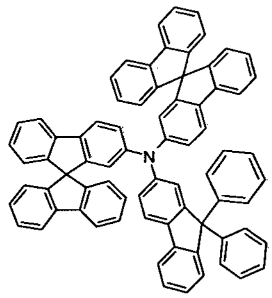 | 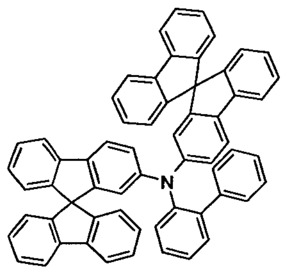 |
| 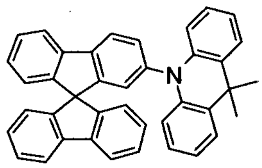 | 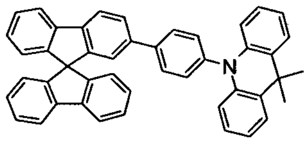 | 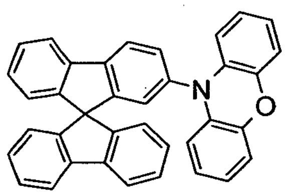 |
| 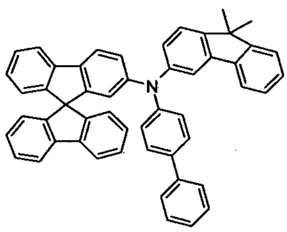 | 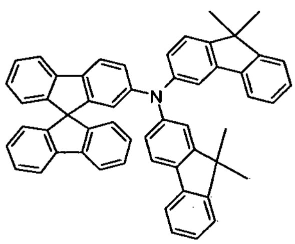 | 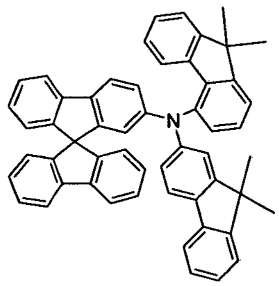 |
| 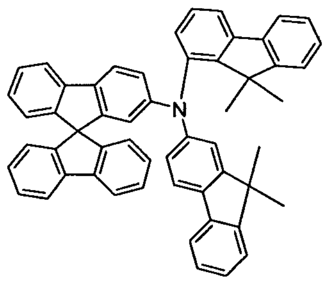 | 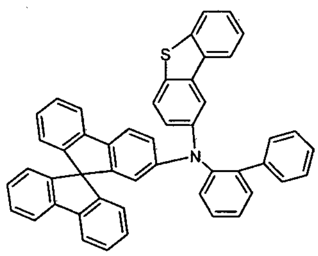 | 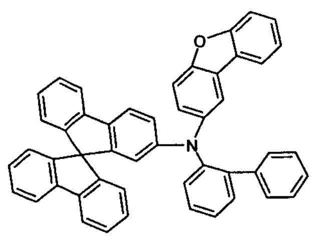 |

| | | |
|---|---|---|
| 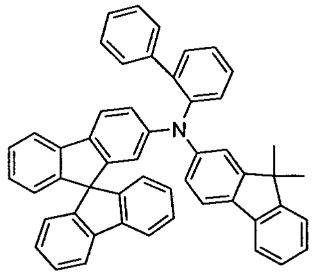 | 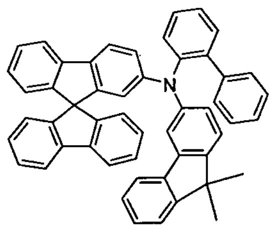 | 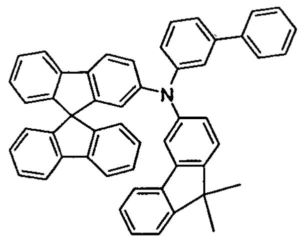 |
| 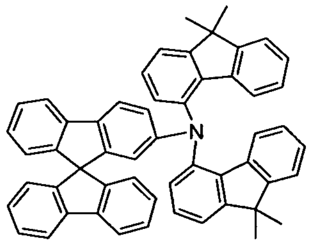 | 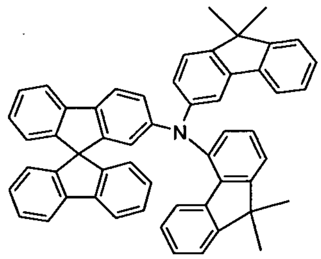 | 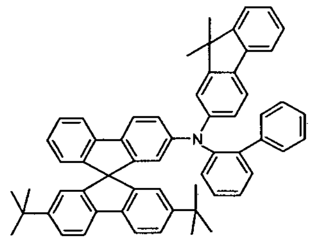 |
| 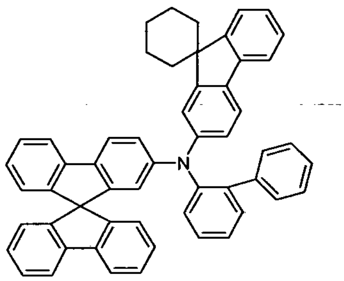 | 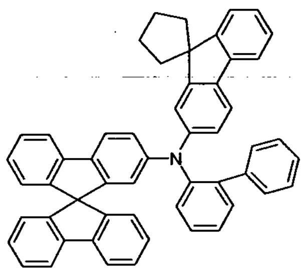 | 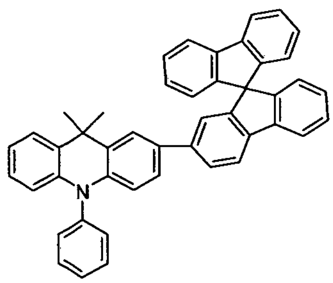 |
| 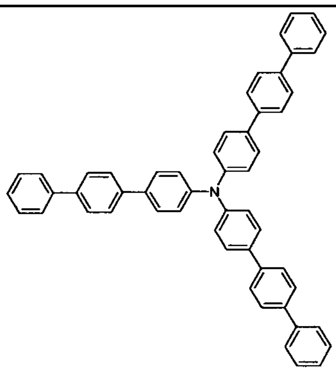 | 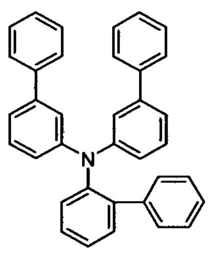 | 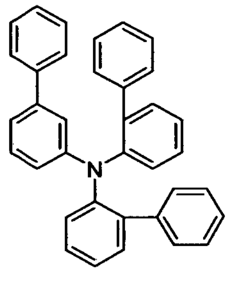 |
| 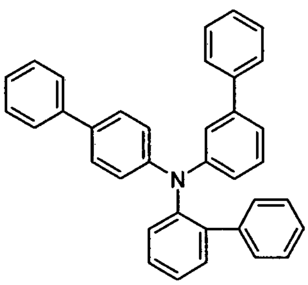 | 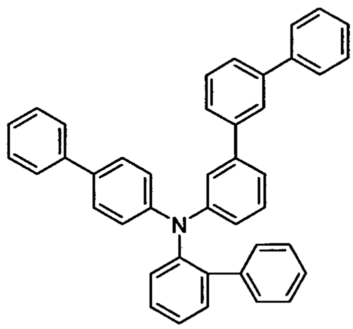 | 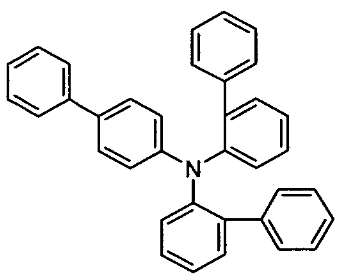 |

| | | |
|---|---|---|
| 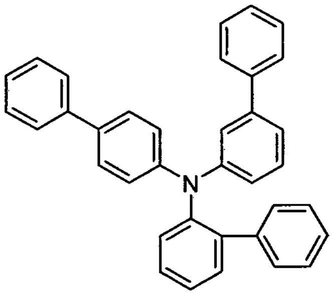 | 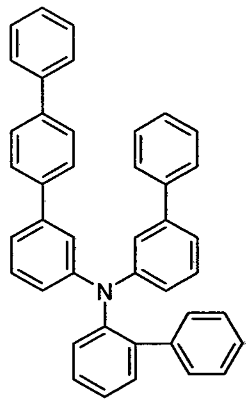 | 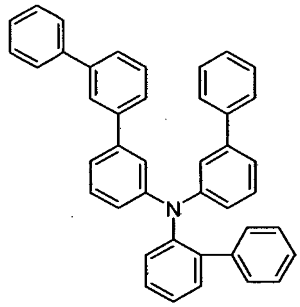 |
| 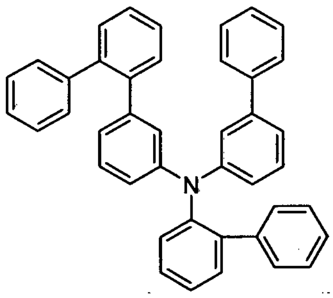 | 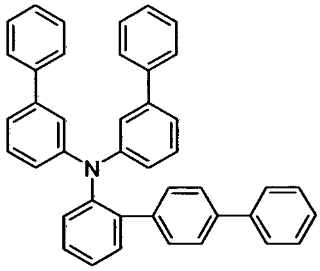 | 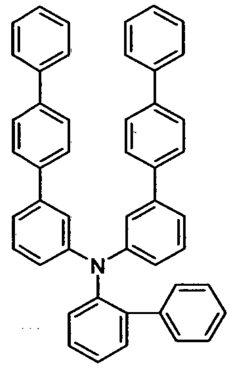 |
| 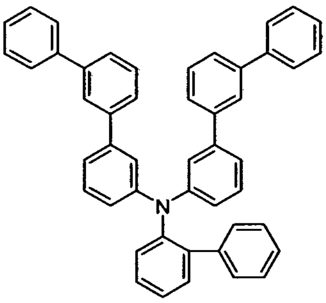 | 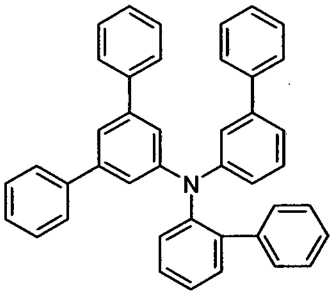 | 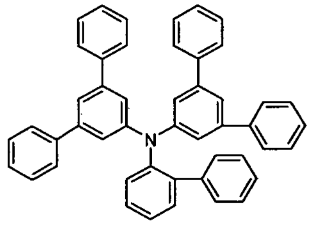 |
| 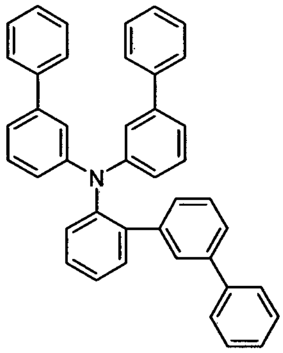 | 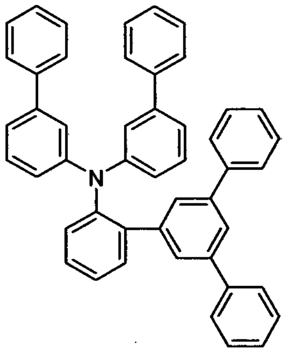 | 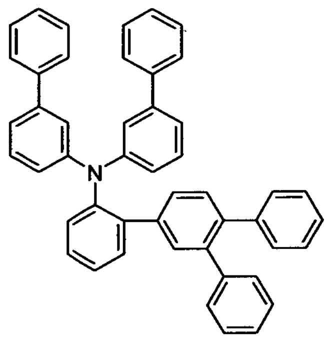 |

| | | |
|---|---|---|
| 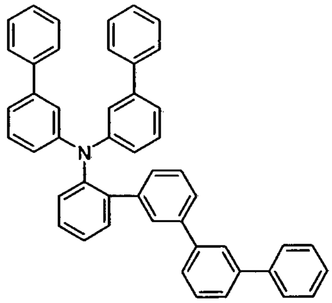 | 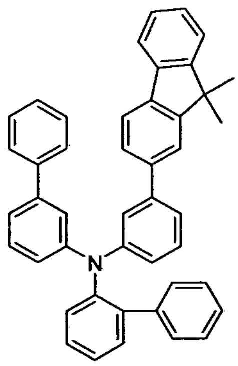 | 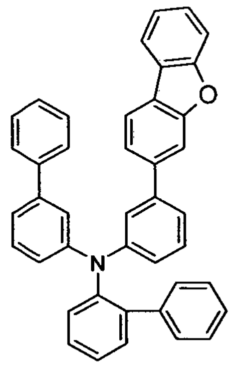 |
| 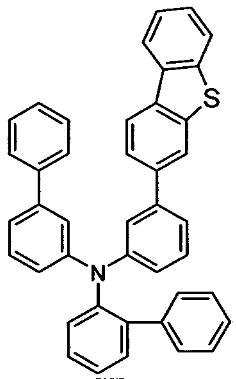 | 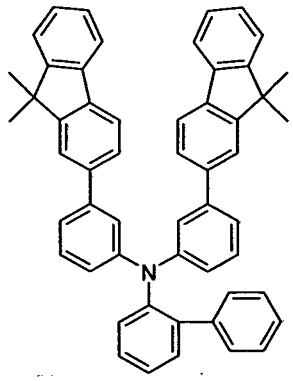 | 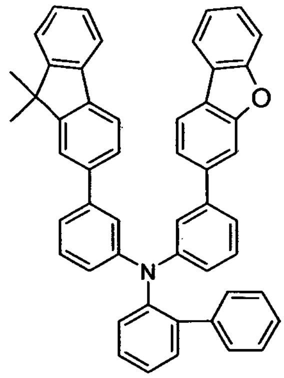 |
| 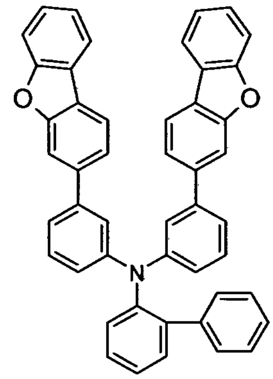 | 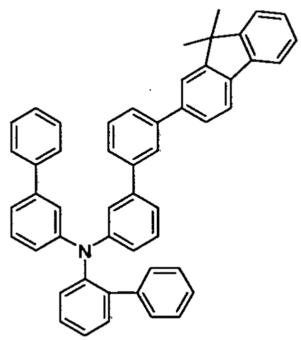 | 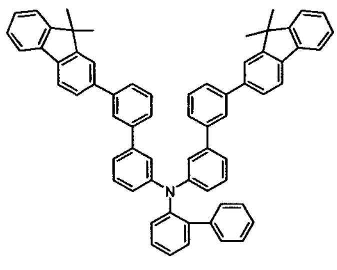 |
| 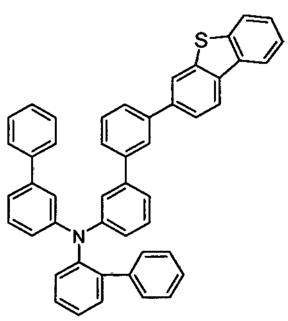 | 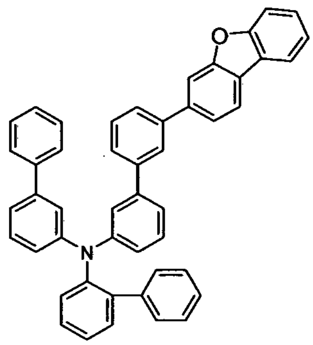 | 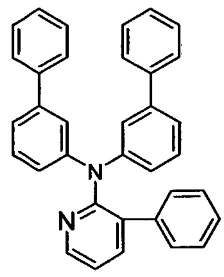 |

| | | |
|---|---|---|
| 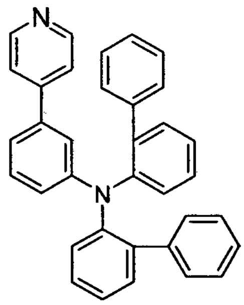 | 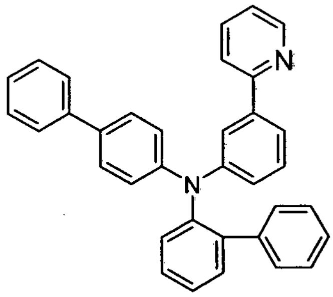 | 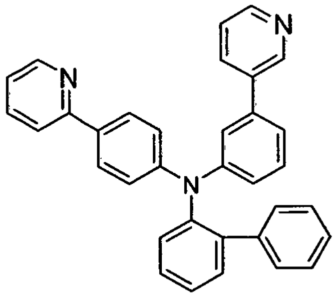 |
| 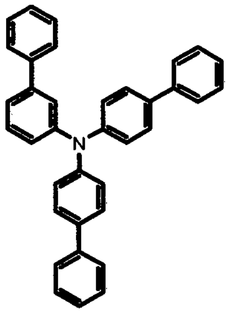 | 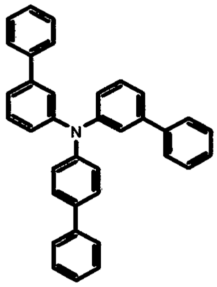 | 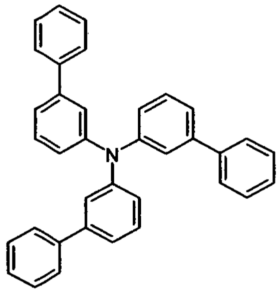 |
| 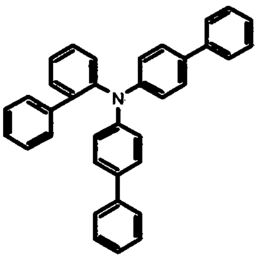 | 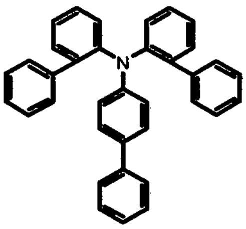 | 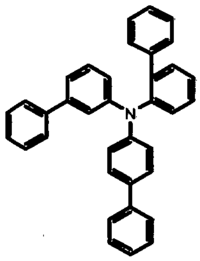 |
| 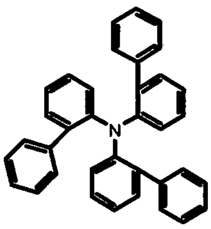 | 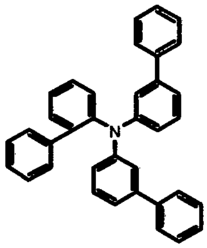 | 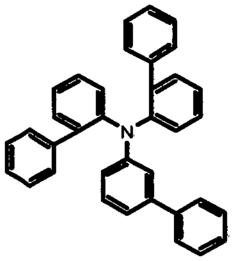 |
| 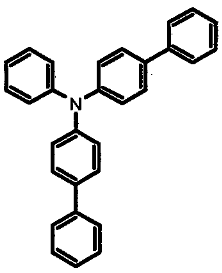 | 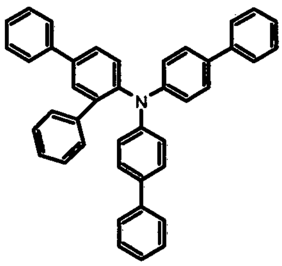 | 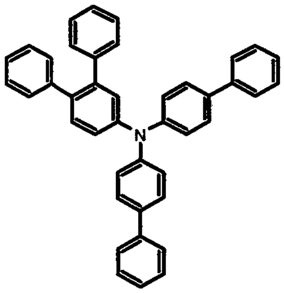 |

| | | |
|---|---|---|
| 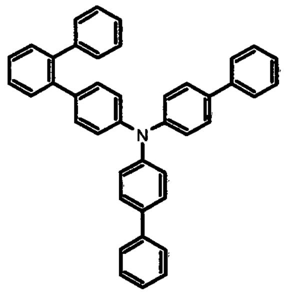 | 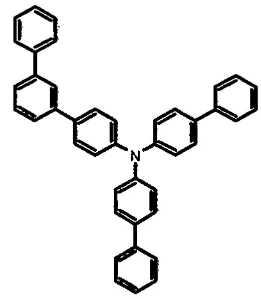 | 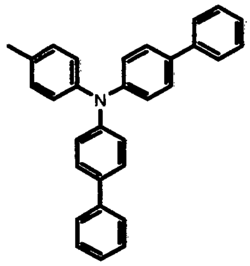 |
| 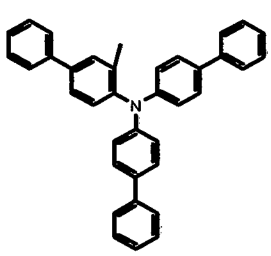 | 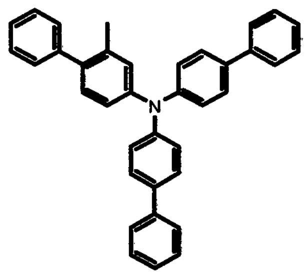 | 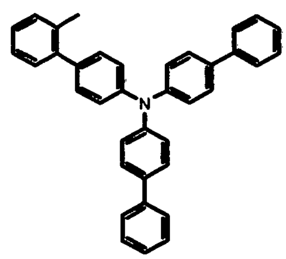 |
| 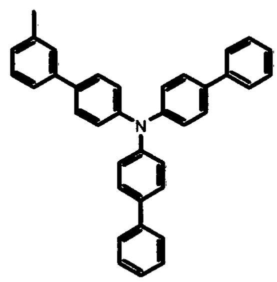 | 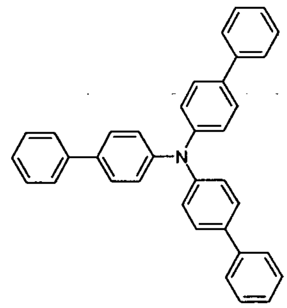 | 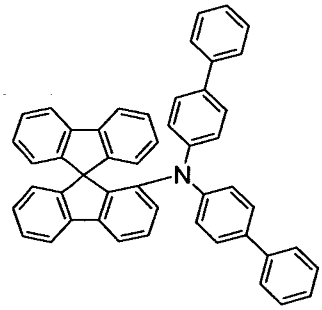 |
| 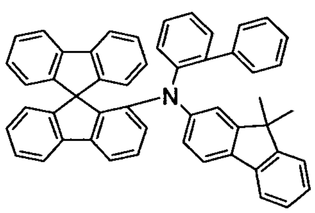 | 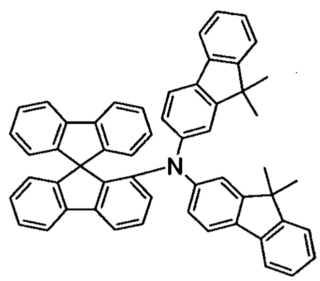 | 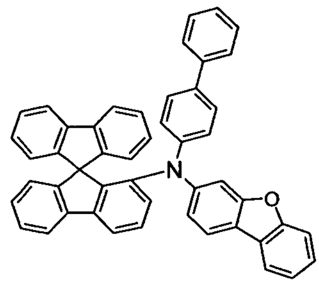 |
| 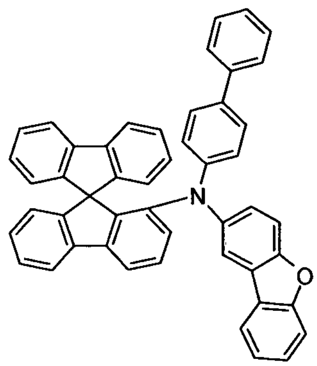 | 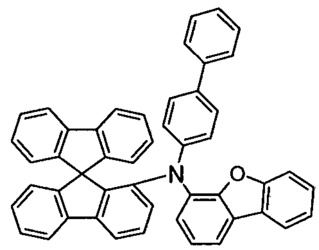 | 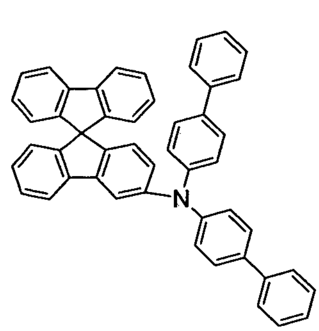 |

| | | |
|---|---|---|
| 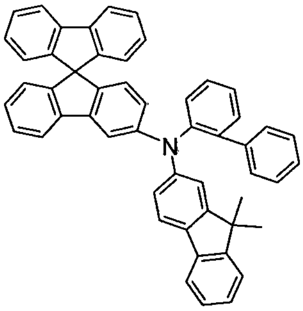 | 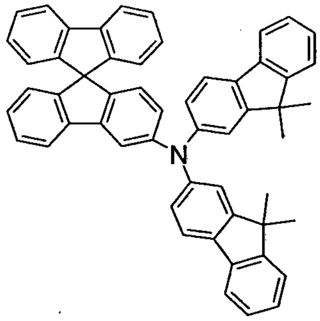 | 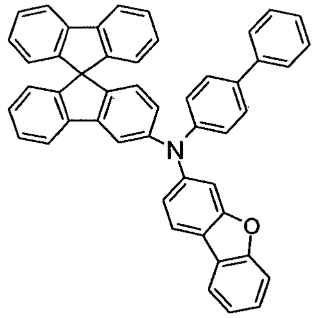 |
| 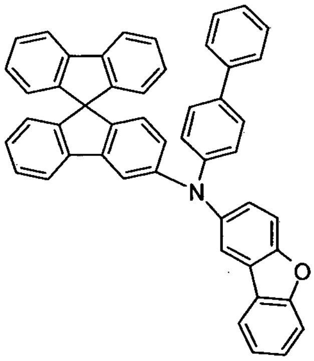 | 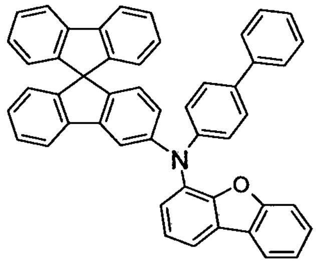 | 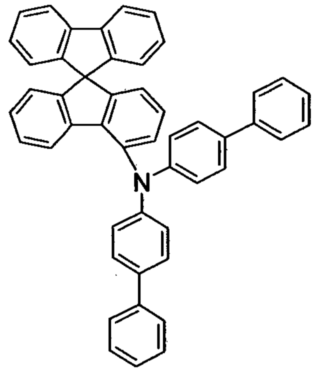 |
| 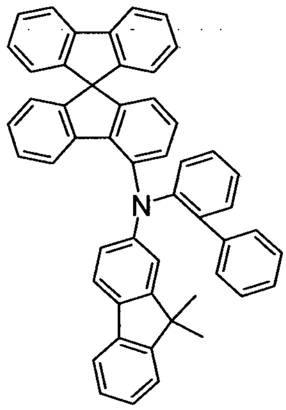 | 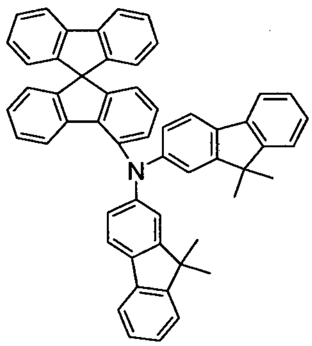 | 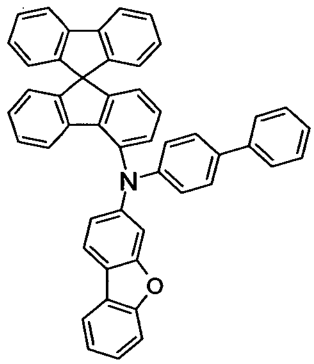 |
| 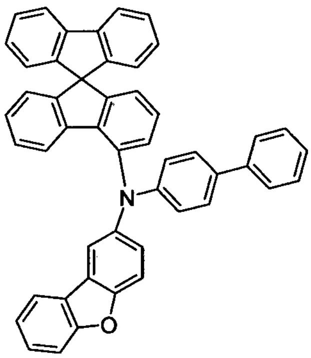 | 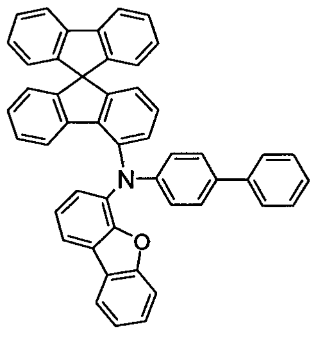 | 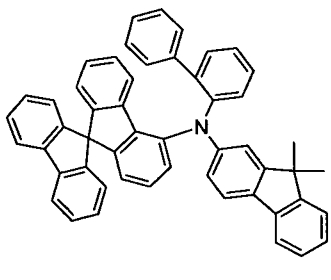 |

| | | |
|---|---|---|
| 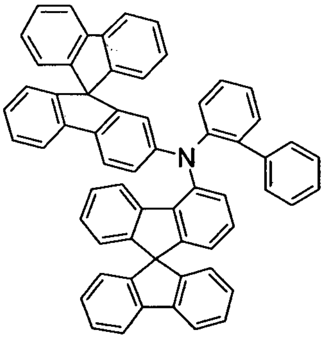 | 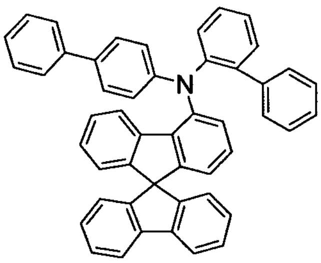 | 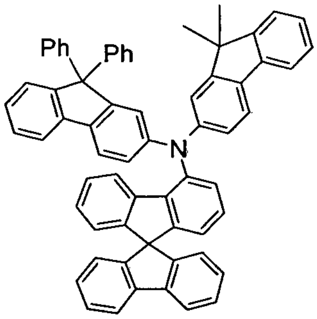 |
| 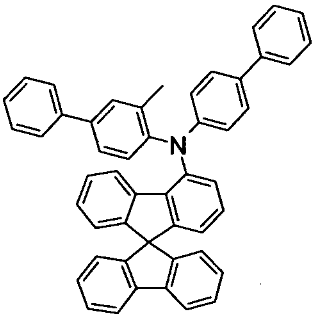 | 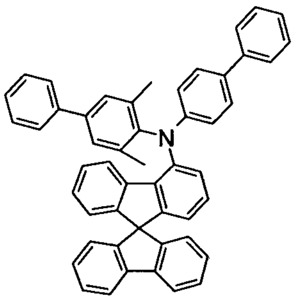 | 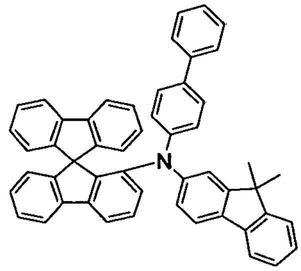 |
| 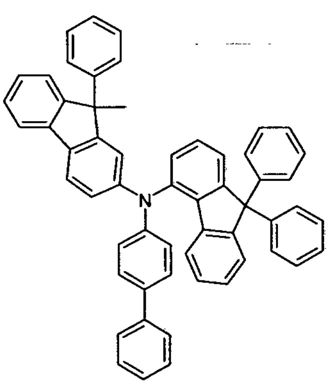 | 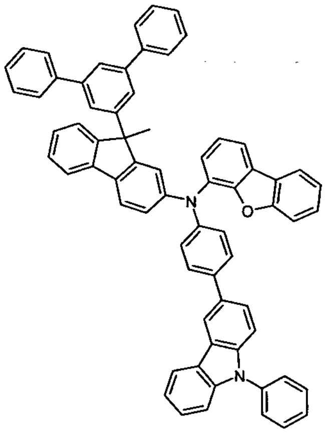 | 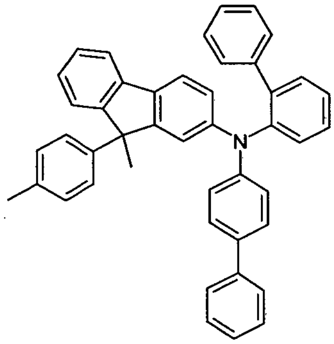 |
| 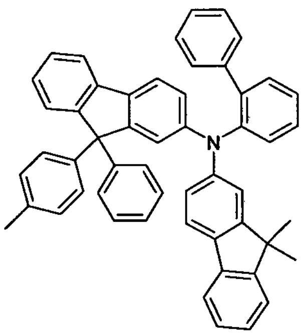 | 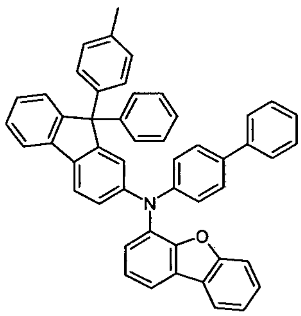 | 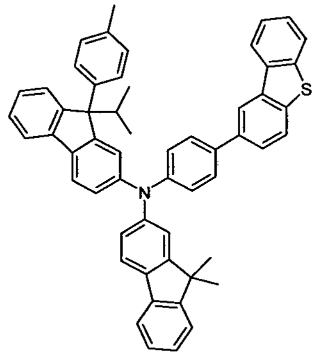 |

| | | |
|---|---|---|
| 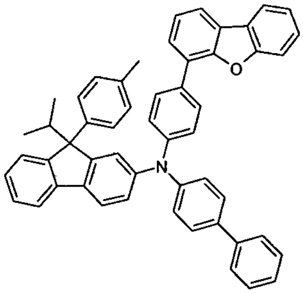 | 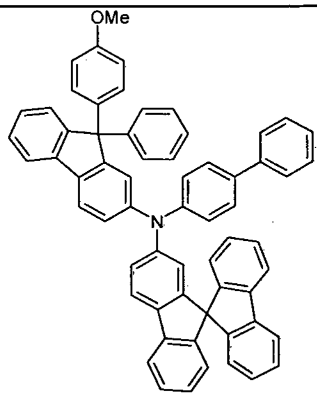 | 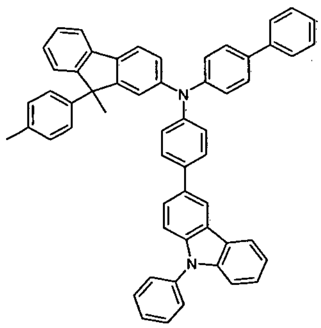 |
| 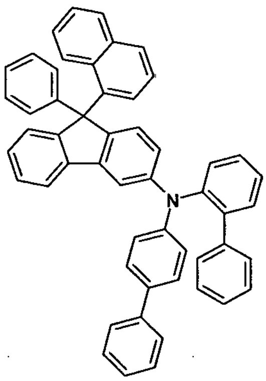 | 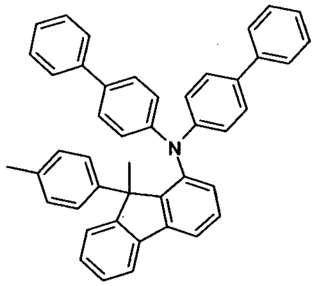 | 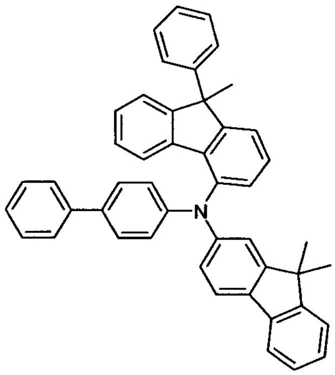 |
| 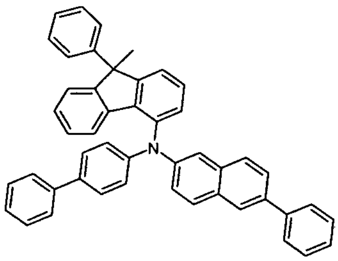 | 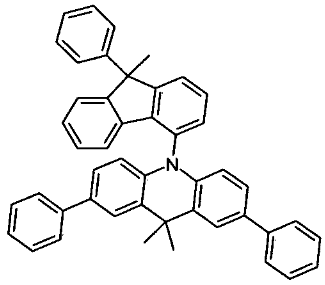 | 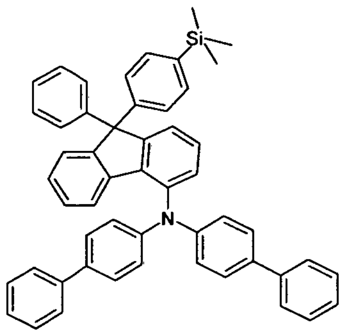 |
| 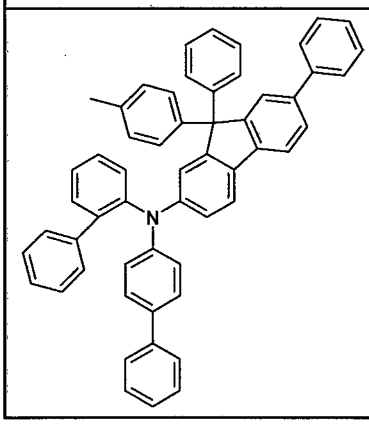 | 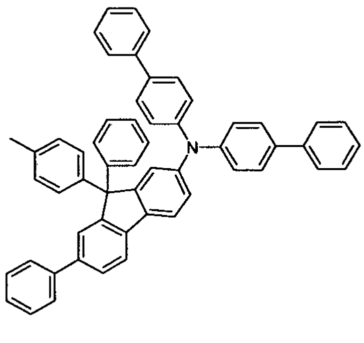 | 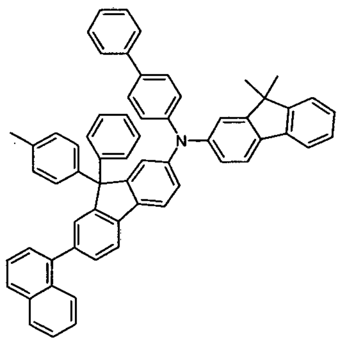 |

| | | |
|---|---|---|
| 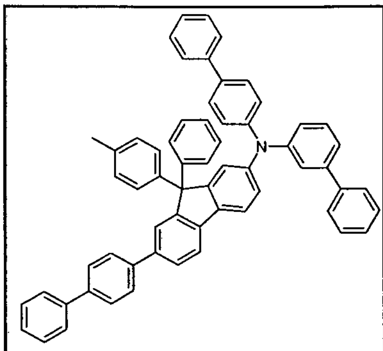 | 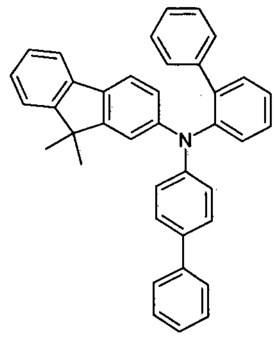 | 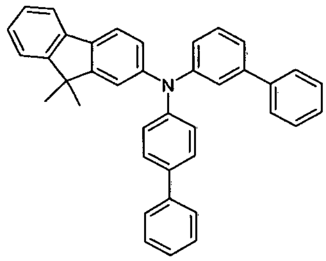 |
| 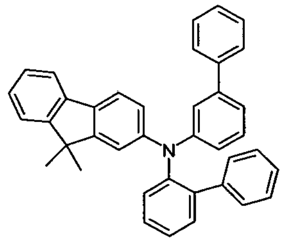 | 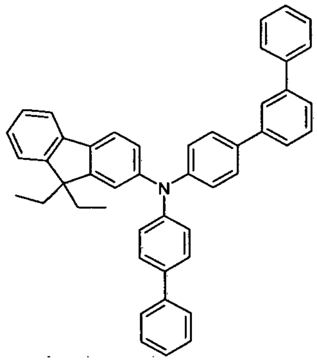 | 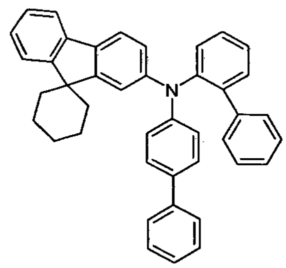 |
| 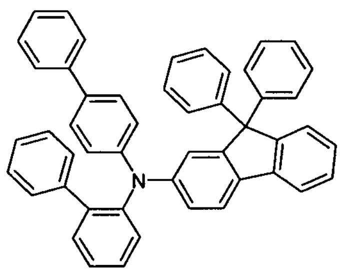 | 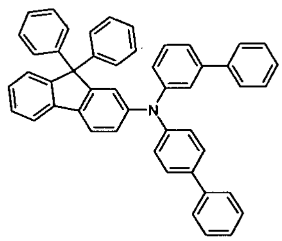 | 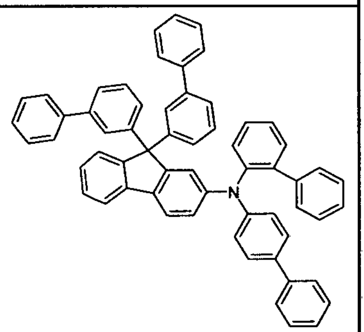 |
| 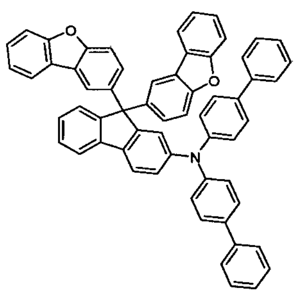 | 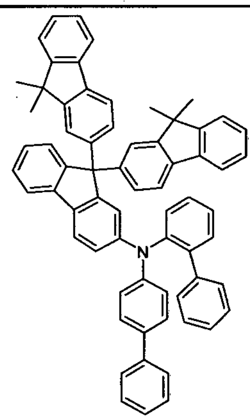 | 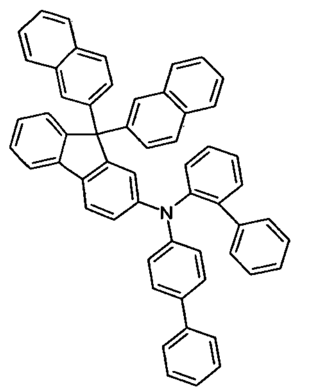 |

| | | |
|---|---|---|
| 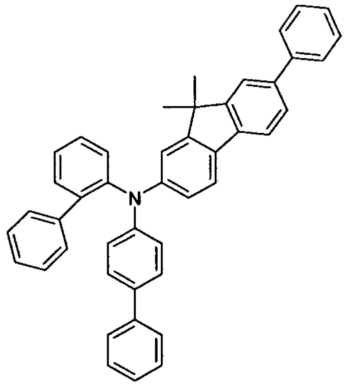 | 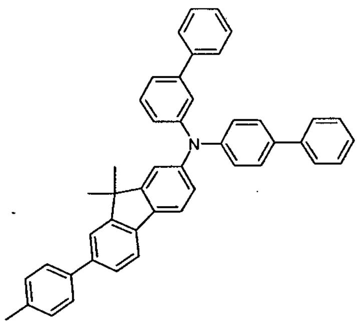 | 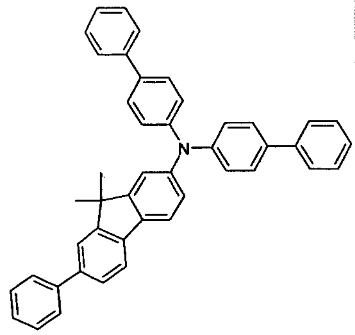 |
| 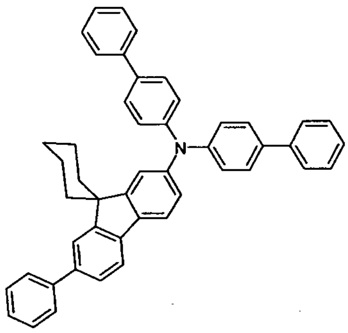 | 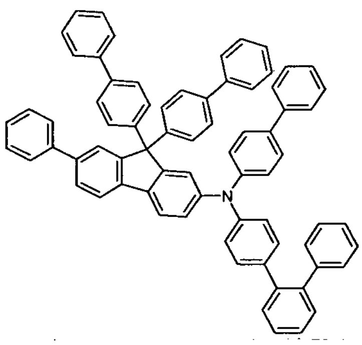 | 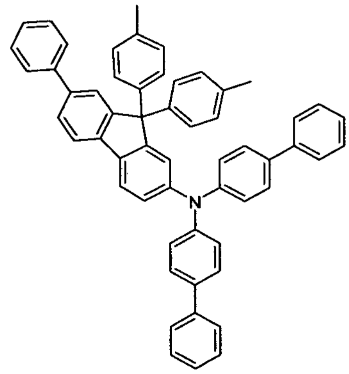 |
| 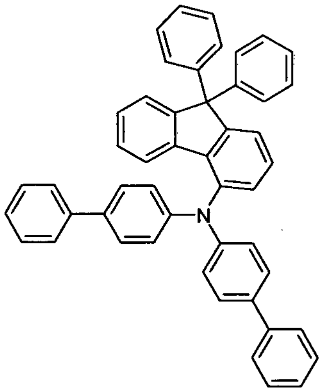 | 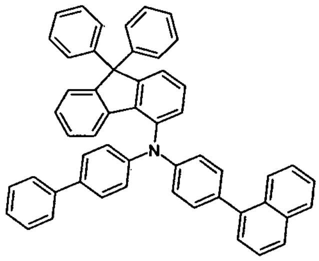 | 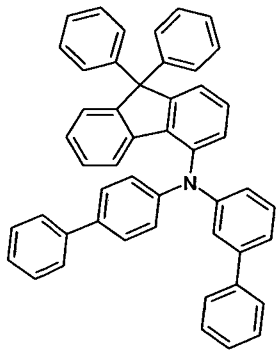 |
| 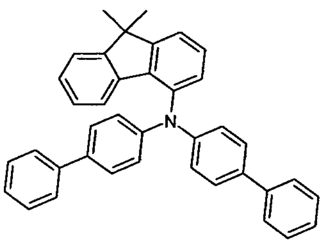 | 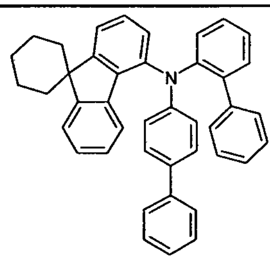 | 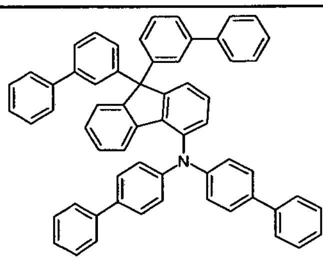 |

| | | |
|---|---|---|
| 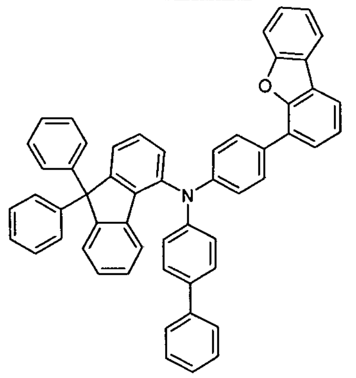 | 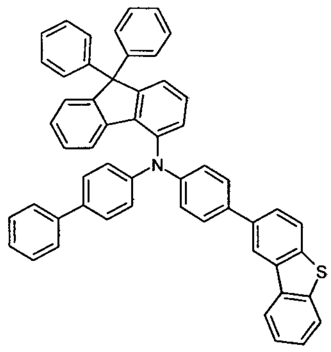 | 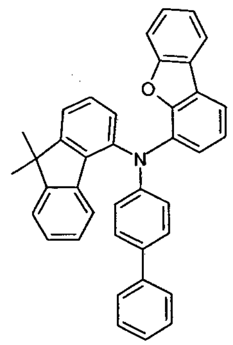 |
| 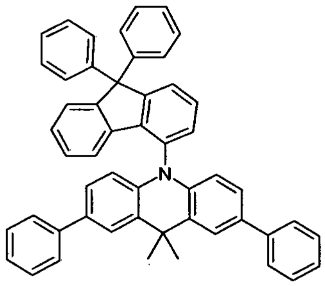 | 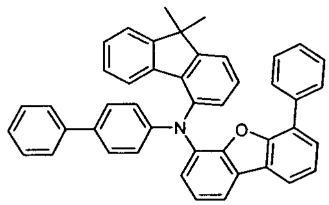 | 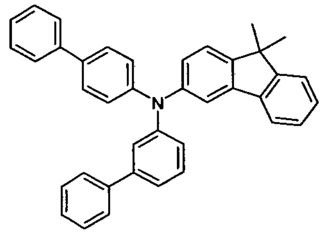 |
| 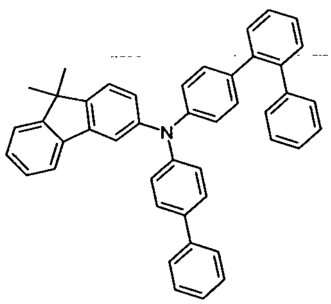 | 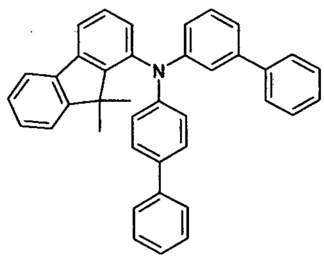 | 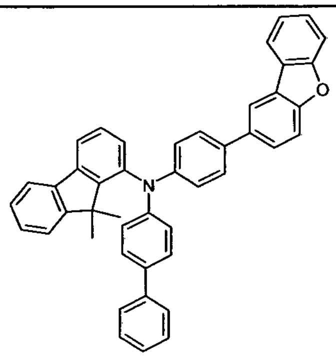 |
| 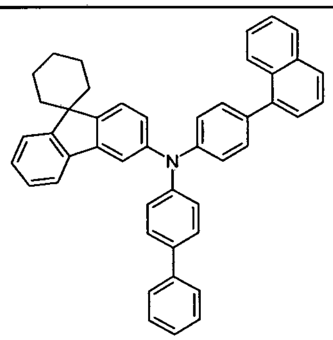 | 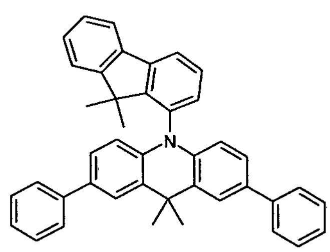 | 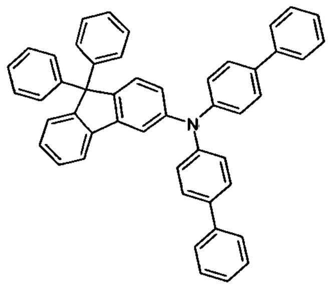 |
| 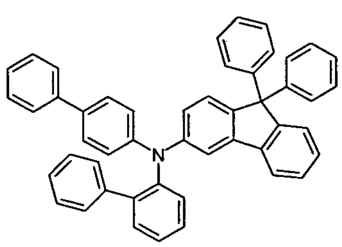 | 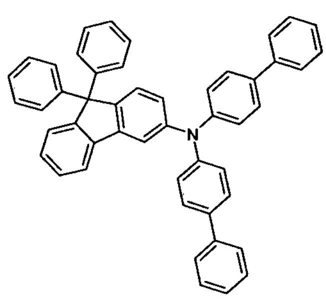 | 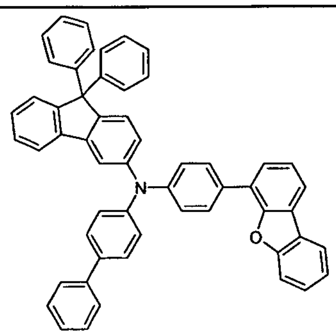 |

| | | |
|---|---|---|
| 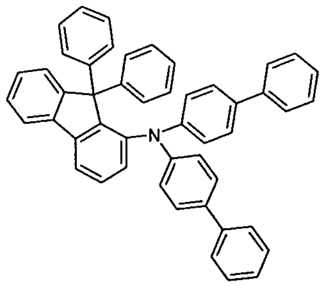 | 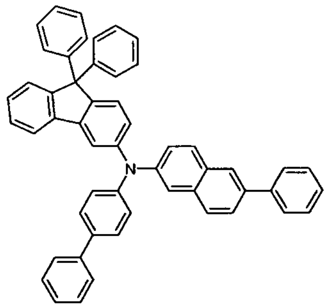 | 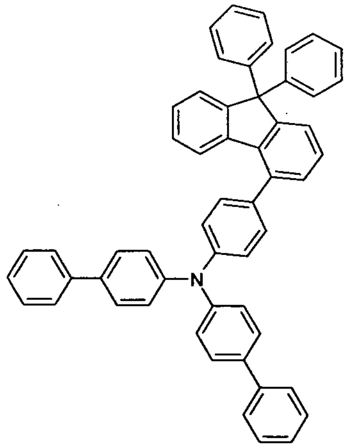 |
| 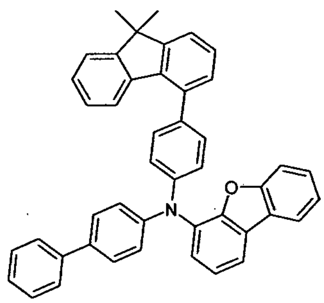 | 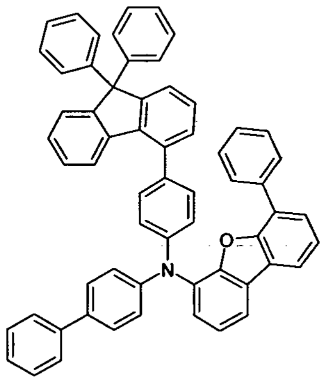 | 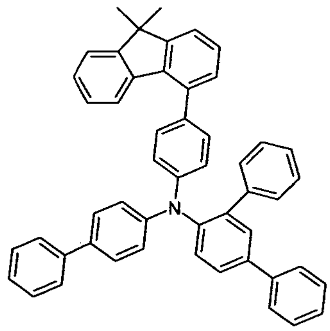 |
| 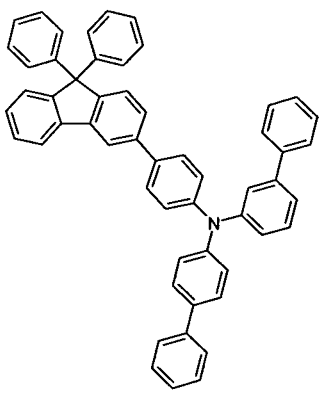 | 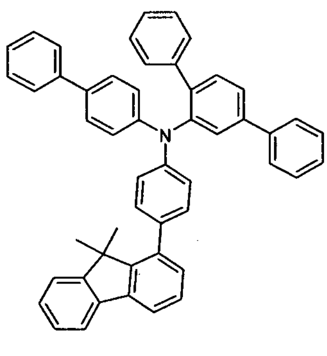 | 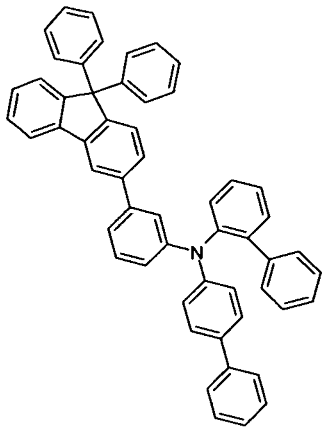 |
| 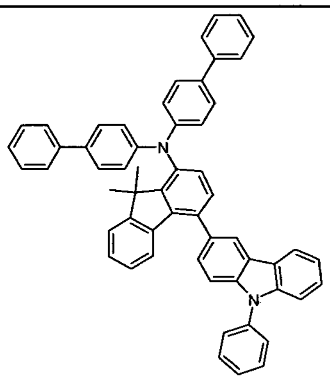 | 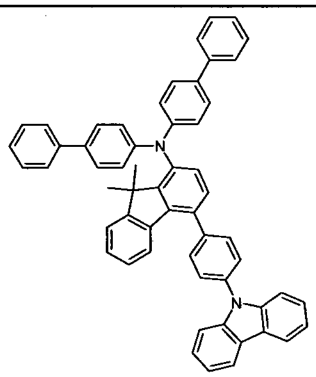 | 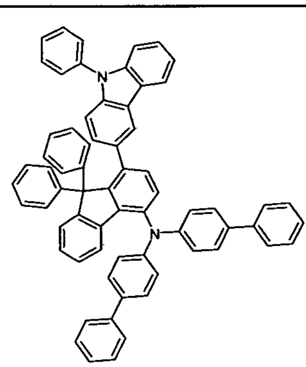 |

| | | |
|---|---|---|
| 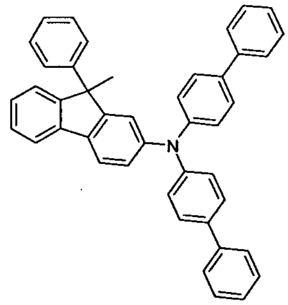 | 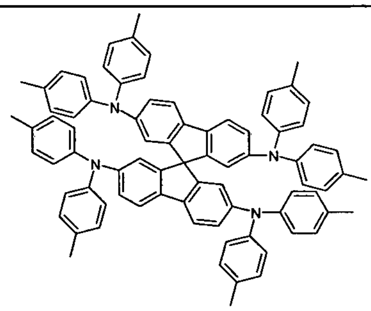 | 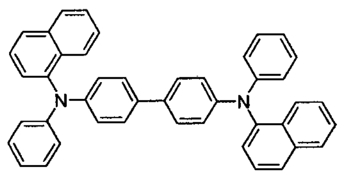 |
| 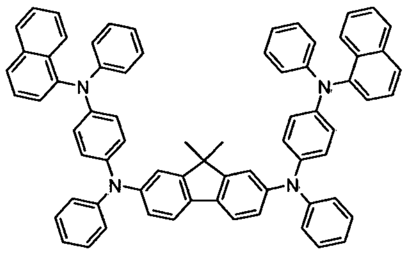 | 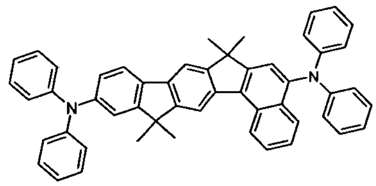 | |
| 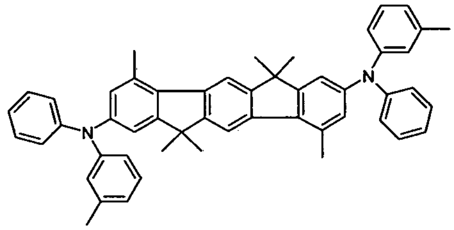 | 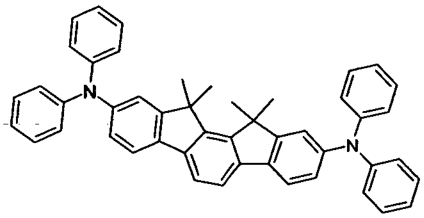 | |
| 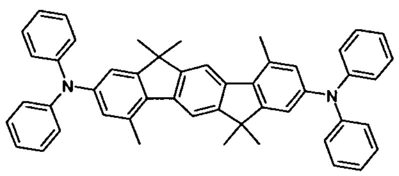 | 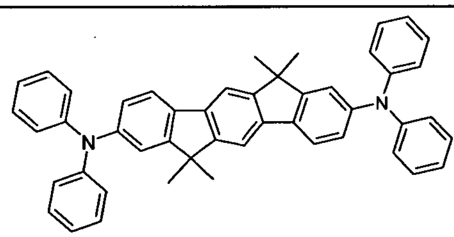 | |
| 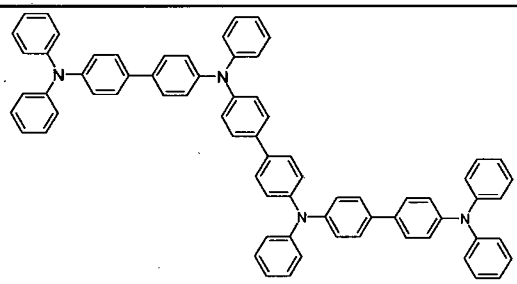 | 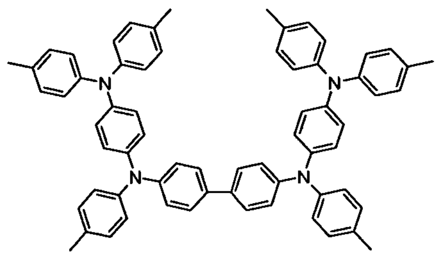 | |
| 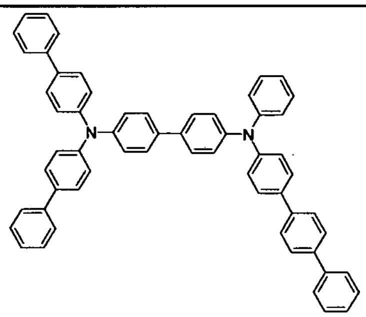 | 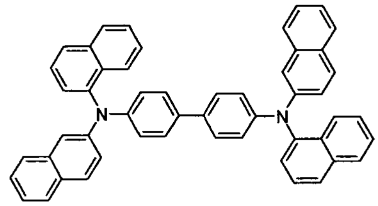 | |

| | |
|---|---|
| 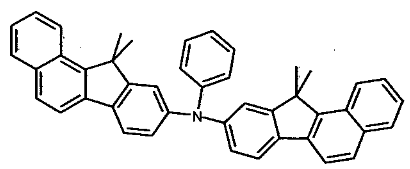 | 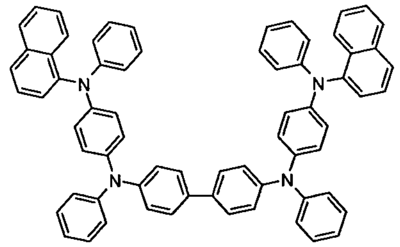 |
| 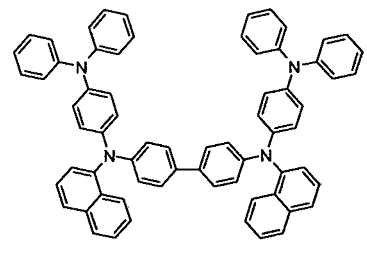 | 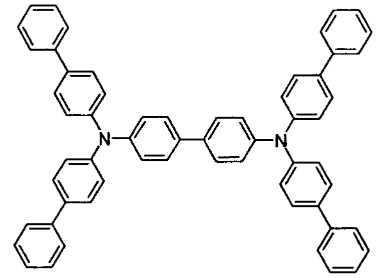 |
| 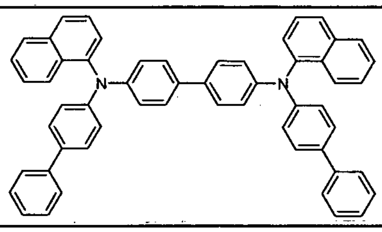 | 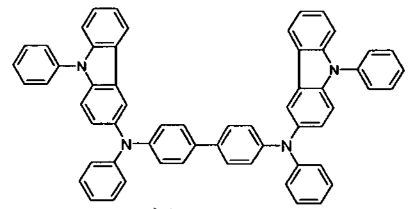 |
| 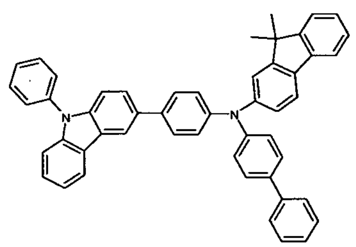 | 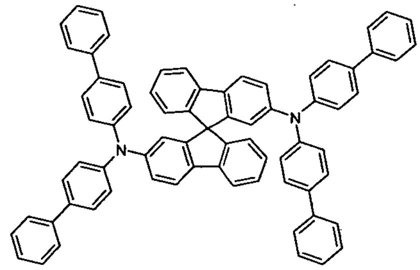 |
| 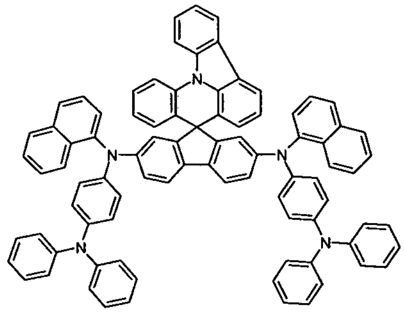 | |

Gemäß einer bevorzugten Ausführungsform enthalten eine oder mehrere der zwischen Anoden-nächster emittierender Schicht EML und Anode angeordneten Schichten einen Dotanden, der eine Elektronenakzeptorverbindung ist. Bevorzugt hat dieser Dotand ein LUMO-Energieniveau, welches kleiner als -4.6 eV ist, besonders bevorzugt kleiner als -4.8 eV und ganz besonders bevorzugt kleiner als -5.0 eV. Am stärksten bevorzugt hat der Dotand ein LUMO-Energieniveau, das kleiner als -5.1 eV ist.

Für die Verwendung als ein solcher Dotand sind prinzipiell alle Verbindungen geeignet, welche Elektronenakzeptorverbindungen darstellen und die Leitfähigkeit der Schicht durch Oxidation des Matrixmaterials erhöhen können. Der Fachmann kann im Rahmen seines allgemeinen Fachwissens ohne größeren Aufwand geeignete Verbindungen identifizieren.

Besonders geeignete Dotanden sind gewählt aus Chinodimethanverbindungen, Azaindenofluorendionen, Azaphenalenen, Azatriphenylenen, $I_2$, Metallhalogeniden, bevorzugt Übergangsmetallhalogeniden, Metalloxiden, bevorzugt Metalloxiden enthaltend mindestens ein Übergangsmetall oder ein Metall der 3. Hauptgruppe, und Übergangsmetallkomplexen, bevorzugt Komplexen von Cu, Co, Ni, Pd und Pt mit Liganden enthaltend mindestens ein Sauerstoffatom

als Bindungsstelle. Bevorzugt sind weiterhin Übergangsmetalloxide als Dotanden, bevorzugt Oxide von Rhenium, Molybdän und Wolfram, besonders bevorzugt $Re_2O_7$, $MoO_3$, $WO_3$ und $ReO_3$.

Bevorzugt liegt ein solcher Dotand in der Schicht in einer Konzentration von 0.1 bis 20 Vol-%, bevorzugt 0.5 bis 12 Vol-%, besonders bevorzugt 1 bis 8 Vol-% und ganz besonders bevorzugt 2 bis 6 Vol-% vor.

Gemäß einer weiteren möglichen Ausführungsform liegt die oben als Dotand beschriebene Elektronenakzeptorverbindung als Reinmaterial in einer Schicht vor, die zwischen Anode und Anoden-nächster emittierender Schicht angeordnet ist.

In Elektronentransportschichten der erfindungsgemäßen Vorrichtung werden bevorzugt organische Verbindungen mit elektronentransportierenden Eigenschaften eingesetzt. Besonders bevorzugt sind elektronentransportierende organische Verbindungen, die ein LUMO-Energieniveau von höchstens -2.50 eV aufweisen, besonders bevorzugt höchstens -2.60 eV, ganz besonders bevorzugt höchstens -2.65 eV, und am stärksten bevorzugt höchstens -2.70 eV.

Als Materialien für die Elektronentransportschicht können alle Materialien verwendet werden, wie sie gemäß dem Stand der Technik als Elektronentransportmaterialien in der Elektronentransportschicht bekannt sind. Insbesondere eignen sich Aluminiumkomplexe, beispielsweise $Alq_3$, Zirkoniumkomplexe, beispielsweise $Zrq_4$, Lithiumkomplexe, beispielsweise Liq, Benzimidazolderivate, Triazinderivate, Pyrimidinderivate, Pyridinderivate, Pyrazinderivate, Chinoxalinderivate, Chinolinderivate, Oxadiazolderivate, aromatische Ketone, Lactame, Borane, Diazaphospholderivate und Phosphinoxidderivate. Weiterhin geeignete Materialien sind Derivate der oben genannten Verbindungen, wie sie in JP 2000/053957, WO 2003/060956, WO 2004/028217, WO 2004/080975 und WO 2010/072300 offenbart werden.

Bevorzugt wird als Material der Elektronentransportschicht eine organische Verbindung verwendet, also eine kohlenstoffhaltige Verbindung, die keine Metalle enthält. Dies ist insbesondere für die Verwendung in der direkt anodenseitig an die emittierende Schicht angrenzenden Schicht bevorzugt.

Die Elektronentransportschicht der erfindungsgemäßen Vorrichtung kann eine Mischung aus zwei oder mehr Materialien enthalten, bevorzugt eine Mischung aus zwei Materialien. Bevorzugt sind dabei die oben angegebenen Materialien. Besonders bevorzugt ist eine Mischung aus einer elektronentransportierenden organischen Verbindung, beispielsweise einer Triazinverbindung, und einem Metallkomplex, beispielsweise Lithiumchinolinat (Liq).

Es ist bevorzugt, dass die Energie des $T_1$-Zustands der Elektronentransportschicht, die direkt an die emittierende Schicht enthaltend die Verbindung E angrenzt, bezeichnet mit $T_1$(ETL), höchstens um 0.1 eV niedriger ist als die Energie des $T_1$-Zustands der Verbindung E, bezeichnet mit $T_1$(E). Insbesondere bevorzugt ist $T_1(ETL) \geq T_1(E)$. Besonders bevorzugt gilt: $T_1(ETL) - T_1(E) \geq 0.1$ eV, ganz besonders bevorzugt $T_1(ETL) - T_1(E) \geq 0.2$ eV. Wenn die Elektronentransportschicht mehr als eine Verbindung enthält, gilt die Bedingung für die Triplettenergie bevorzugt für jede der Verbindungen.

Als Kathode der erfindungsgemäßen Vorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Ebenso bevorzugt sind Metalllegierungen, insbesondere Legierungen aus einem Alkalimetall oder Erdalkalimetall und Silber, besonders bevorzugt eine Legierung aus Mg und Ag. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, CsF, $Cs_2CO_3$, $BaF_2$, MgO, NaF, etc.). Ebenso kommen organische Alkali- oder Erdalkalikomplexe in Frage, wie z. B. Lithiumchinolinat (LiQ). Die Schichtdicke dieser Schicht beträgt bevorzugt zwischen 0.5 und 5 nm.

Als Anode der erfindungsgemäßen Vorrichtung sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. $Al/Ni/NiO_x$, $Al/PtO_x$) bevorzugt sein. Dabei muss mindestens eine der Elektroden transparent oder teiltransparent sein, um die Auskopplung von Licht zu ermöglichen. Bevorzugte transparente oder teiltransparente Anodenmaterialien sind leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich versiegelt, um schädigende Effekte von Wasser und Luft auszuschließen.

Verfahren zur Herstellung der erfindungsgemäßen Vorrichtung, insbesondere zur Aufbringung der Schichten, sind dem Fachmann bekannt.

Bevorzugt ist die erfindungsgemäße Vorrichtung dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Es ist aber auch möglich, dass der Anfangsdruck noch geringer ist, beispielsweise kleiner $10^{-7}$ mbar.

Gemäß einem alternativen Herstellungsverfahren ist die erfindungsgemäße Vorrichtung dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Gemäß einem alternativen Herstellungsverfahren ist die erfindungsgemäße Vorrichtung dadurch gekennzeichnet, dass eine oder mehrere Schichten aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt werden.

Weiterer Gegenstand der Erfindung ist daher ein Verfahren zur Herstellung der erfindungsgemäßen Vorrichtung, dadurch gekennzeichnet, dass mindestens eine Schicht mit einem Sublimationsverfahren aufgebracht wird, oder dass mindestens eine Schicht mit einem OVPD (Organic Vapour Phase Deposition) Verfahren aufgebracht wird, oder dass mindestens eine Schicht mit Hilfe einer Trägergassublimation aufgebracht wird, oder dass mindestens eine Schicht aus Lösung aufgebracht wird.

**Ausführungsbeispiele**

**1) Bestimmung der HOMO-, LUMO-, $S_1$- und $T_1$-Energien von Verbindungen**

Die HOMO- und LUMO-Energieniveaus sowie die Energie des niedrigsten Triplettzustands $T_1$ bzw. niedrigsten angeregten Singulettzustands $S_1$ von Verbindungen werden über quantenchemische Rechnungen bestimmt. Hierzu wird das Programmpaket "Gaussian09W" (Gaussian Inc.) verwendet. Zur Berechnung organischer Substanzen ohne Metalle wird zuerst eine Geometrieoptimierung mit der Methode "Ground State/Semiempirical/Default Spin/AM1/Charge 0/Spin Singlet" durchgeführt. Im Anschluss erfolgt auf Grundlage der optimierten Geometrie eine Energierechnung. Hierbei wird die Methode "TD-SFC/DFT/Default Spin/B3PW91" mit dem Basissatz "6-31G(d)" verwendet (Charge 0, Spin Singlet). Für metallhaltige Verbindungen wird die Geometrie über die Methode "Ground State/ Hartree-Fock/Default Spin/LanL2MB/Charge 0/Spin Singlet" optimiert. Die Energierechnung erfolgt analog zu den organischen Substanzen, wie oben beschrieben, mit dem Unterschied, dass für das Metallatom der Basissatz "LanL2DZ" und für die Liganden der Basissatz "6-31G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$\mathrm{HOMO(eV)} = ((\mathrm{HEh}*27.212)-0.9899)/1.1206$$

$$\mathrm{LUMO(eV)} = ((\mathrm{LEh}*27.212)-2.0041)/1.385$$

Diese Werte sind im Sinne dieser Anmeldung als HOMO- bzw. LUMO-Energieniveaus der Verbindungen anzusehen.

Die Energie des $T_1$-Zustands ist definiert als die Energie des Triplettzustands mit der niedrigsten Energie, der sich aus der oben beschriebenen quantenchemischen Rechnung ergibt.

Die Energie des $S_1$-Zustands ist definiert als die Energie des niedrigsten angeregten Singulettzustands, der sich aus der oben beschriebenen quantenchemischen Rechnung ergibt.

In der folgenden Tabelle 1 sind die HOMO- und LUMO-Energieniveaus sowie die berechneten Energien der $S_1$- und $T_1$-Zustände für verschiedene Verbindungen (Strukturen vgl. Tabelle 4) angegeben.

Tabelle 1: HOMO-, LUMO-, $T_1$- und $S_1$-Energien der Verbindungen

| Material | HOMO (eV) | LUMO (eV) | $S_1$ (eV) | $T_1$ (eV) |
|---|---|---|---|---|
| D1 | -6.11 | -3.40 | 2.50 | 2.41 |
| CBP | -5.67 | -2.38 | 3.59 | 3.11 |
| BCP | -6.15 | -2.44 | 3.61 | 2.70 |
| IC1 | -5.79 | -2.83 | 3.09 | 2.69 |
| IC5 | -5.56 | -2.87 | 2.87 | 2.72 |

(fortgesetzt)

| Material | HOMO (eV) | LUMO (eV) | $S_1$ (eV) | $T_1$ (eV) |
|---|---|---|---|---|
| IC3 | -5.62 | -2.75 | 3.02 | 2.75 |
| SpA1 | -4.87 | -2.14 | 2.94 | 2.34 |
| SpMA1 | -5.25 | -2.18 | 3.34 | 2.58 |
| SpMA2 | -5.35 | -2.34 | 3.14 | 2.62 |
| IC2 | -5.40 | -2.11 | 3.24 | 2.80 |
| NPB | -5.22 | -2.28 | 3.19 | 2.45 |
| IC4 | -5.74 | -2.23 | 3.59 | 2.72 |
| HAT | -8.86 | -4.93 | n. ber. | n. ber. |
| F4T | -7.91 | -5.21 | n. ber. | n. ber. |
| ST2 | -6.03 | -2.82 | 3.32 | 2.68 |

**2) Bestimmung der Lumineszenzquanteneffizienz (PLQE)**

Von den in den verschiedenen OLEDs verwendeten Emissionsschichten wird ein 50 nm dicker Film auf ein geeignetes transparentes Substrat, vorzugsweise Quarz, aufgebracht, d. h. die Schicht enthält dieselben Materialien in derselben Konzentration wie in der OLED. Hierbei werden die gleichen Herstellbedingungen wie bei der Herstellung der Emissionsschicht für die OLEDs verwendet. Von diesem Film wird ein Absorptionsspektrum im Wellenlängenbereich von 350-500 nm gemessen. Hierzu werden das Reflektionsspektrum $R(\lambda)$ und das Transmissionsspektrum $T(\lambda)$ der Probe unter einem Einfallswinkel von 6° (also nahezu senkrechter Einfall) bestimmt. Als Absorptionsspektrum im Sinne dieser Anmeldung wird $A(\lambda)=1-R(\lambda)-T(\lambda)$ definiert.

Gilt $A(\lambda) \leq 0.3$ im Bereich 350-500 nm, so wird die zum Maximum des Absorptionsspektrums gehörige Wellenlänge im Bereich 350-500 nm als $\lambda_{exc}$ definiert. Gilt für irgendeine Wellenlänge $A(\lambda) > 0.3$, so wird als $\lambda_{exc}$ die größte Wellenlänge definiert, bei der $A(\lambda)$ von einem Wert kleiner 0.3 zu einem Wert größer 0.3 oder von einem Wert größer 0.3 zu einem Wert kleiner 0.3 wechselt.

Zur Bestimmung der PLQE wird ein Messplatz Hamamatsu C9920-02 verwendet. Das Prinzip beruht auf der Anregung der Probe mit Licht definierter Wellenlänge und der Messung der absorbierten und emittierten Strahlung. Die Probe befindet sich während der Messung in einer Ulbrichtkugel ("integrating sphere"). Das Spektrum des Anregungslichts ist in etwa gaußförmig mit einer Halbwertsbreite <10 nm und einer Peakwellenlänge $\lambda_{exc}$ wie oben definiert. Die PLQE wird nach dem für den genannten Messplatz üblichen Auswerteverfahren bestimmt. Es ist strengstens darauf zu achten, dass die Probe zu keinem Zeitpunkt mit Sauerstoff in Berührung kommt, da die PLQE von Materialien mit kleinem energetischen Abstand zwischen $S_1$ und $T_1$ durch Sauerstoff sehr stark reduziert wird (H. Uoyama et al., Nature 2012, Vol. 492, 234).

In Tabelle 3 ist die wie oben angegeben ermittelte PLQE für die Emissionsschichten verschiedener OLEDs zusammen mit der verwendeten Anregungswellenlänge $\lambda_{exc}$ angegeben.

**3) Bestimmung der Abklingzeit**

Zur Bestimmung der Abklingzeit wird eine Probe verwendet, die wie oben unter "Bestimmung der Lumineszenzquanteneffizienz (PLQE)" beschrieben hergestellt wird. Die Probe wird bei einer Temperatur von 295 K durch einen Laserpuls angeregt (Wellenlänge 266 nm, Pulsdauer 1.5 ns, Pulsenergie 200 $\mu$J, Strahldurchmesser 4 mm). Die Probe befindet sich hierbei im Vakuum ($<10^{-5}$ mbar). Nach der Anregung (definiert als t = 0) wird der zeitliche Verlauf der Intensität der emittierten Photolumineszenz gemessen. Die Photolumineszenz zeigt am Anfang einen steilen Abfall, der auf die prompte Fluoreszenz der TADF-Verbindung zurückzuführen ist. Im weiteren zeitlichen Verlauf ist ein langsamerer Abfall zu beobachten, die verzögerte Fluoreszenz (siehe z.B. H. Uoyama et al., Nature, vol. 492, no. 7428, pp. 234-238, 2012 sowie K. Masui et al., Organic Electronics, vol. 14, no. 11, pp. 2721-2726, 2013). Die Abklingzeit $t_a$ im Sinne dieser Anmeldung ist die Abklingzeit der verzögerten Fluoreszenz und wird wie folgt bestimmt: Man wählt einen Zeitpunkt $t_d$, zu dem die prompte Fluoreszenz deutlich unter die Intensität der verzögerten Fluoreszenz abgeklungen ist (<1%), so dass die folgende Bestimmung der Abklingzeit davon nicht beeinflusst wird. Diese Wahl kann von einem Fachmann durchgeführt werden. Für die Messdaten ab dem Zeitpunkt $t_d$ wird die Abklingzeit $t_a = t_e - t_d$ bestimmt. Dabei ist $t_e$ derjenige Zeitpunkt nach $t = t_d$, bei dem die Intensität erstmals auf 1/e ihres Wertes bei $t = t_d$ abgefallen ist.

Tabelle 3 zeigt die Werte von $t_a$ und $t_d$, die für die Emissionsschichten der vermessenen OLEDs ermittelt werden.

**4) Herstellung der OLEDs**

In den folgenden Beispielen V1 bis V6 und E1 bis E7 (siehe Tabelle 2 für Aufbau der OLEDs und Tabelle 3 für erhaltene Messdaten) werden die Daten verschiedener OLEDs vorgestellt.

Glasplättchen, die mit strukturiertem ITO (Indium Zinn Oxid) der Dicke 50 nm beschichtet sind, bilden die Substrate für die OLEDs. Die Substrate werden nass gereinigt (Spülmaschine, Reiniger Merck Extran), anschliessend 15 min lang bei 250°C ausgeheizt und vor der Beschichtung 130 s lang mit einem Sauerstoffplasma behandelt. Diese mit Plasma behandelten Glasplättchen bilden die Substrate, auf welche die OLEDs aufgebracht werden. Die Substrate verbleiben vor der Beschichtung im Vakuum. Die Beschichtung beginnt spätestens 10 min nach der Plasmabehandlung.

Die OLEDs haben den folgenden Schichtaufbau: Substrat / optionale Lochtransportschichten 1-4 (HTL1-4) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 2 zu entnehmen. Die zur Herstellung der OLEDs benötigten Materialien sind in Tabelle 4 aufgeführt.

Alle Materialien werden in einer Vakuumkammer thermisch aufgedampft. Dabei besteht die Emissionsschicht immer aus einem Matrixmaterial und dem emittierenden Material, das einen geringen Unterschied zwischen den Energien des $S_1$- und des $T_1$-Zustands aufweist. Dieses wird dem Matrixmaterial durch Coverdampfung in einem bestimmten Volumenanteil beigemischt. Eine Angabe wie IC1:D1 (95%:5%) bedeutet hierbei, dass das Material IC1 in einem Volumenanteil von 95% und D1 in einem Anteil von 5% in der Schicht vorliegt. Analog können auch andere Schichten, beispielsweise die Lochtransportschicht, aus einer Mischung von mehreren Materialien bestehen.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik, sowie die Lebensdauer bestimmt. Die Elektrolumineszenzspektren werden bei einer Leuchtdichte von 1000 cd/$m^2$ bestimmt und daraus die CIE 1931 x und y Farbkoordinaten berechnet. Die Angabe U1000 in Tabelle 3 bezeichnet die Spannung, die für eine Leuchtdichte von 1000 cd/$m^2$ benötigt wird. SE1000 und LE1000 bezeichnen die Strom- bzw. Leistungseffizienz, die bei 1000 cd/$m^2$ erreicht werden. EQE1000 schließlich bezeichnet die externe Quanteneffizienz bei einer Betriebsleuchtdichte von 1000 cd/$m^2$. Als Lebensdauer LD wird die Zeit definiert, nach der die Leuchtdichte bei Betrieb mit konstantem Strom von der Startleuchtdichte auf einen gewissen Anteil L1 absinkt. Eine Angabe von j0 = 10mA/$cm^2$, L1 = 80% in Tabelle 3 bedeutet, dass die Leuchtdichte bei Betrieb mit 10mA/$cm^2$ nach der Zeit LD auf 80% ihres Anfangswertes absinkt.

Die Daten der verschiedenen OLEDs sind in Tabelle 3 zusammengefasst. Die Beispiele V1-V6 sind Vergleichsbeispiele gemäß dem Stand der Technik, die Beispiele E1-E7 zeigen Daten von erfindungsgemäßen OLEDs.

Tabelle 5 zeigt die HOMO- bzw. LUMO-Energiedifferenzen zwischen benachbarten Lochtransportschichten bzw. der an die Emissionsschicht angrenzenden Lochtransportschicht und der Emissionsschicht. Eine Angabe wie HTL1-HTL2 bedeutet dabei, dass es sich um die Energiedifferenz D zwischen den Schichten HTL1 und HTL2 handelt mit D=E(HTL1)-E(HTL2). Ist HOMO(HTL1) kleiner oder gleich -6.7eV, so gilt E(HTL1)=LUMO(HTL1), ansonsten ist E(HTL1)=HOMO(HTL1). Ist HOMO(HTL2) kleiner oder gleich -6.7eV, so gilt E(HTL2)=LUMO(HTL2), ansonsten ist E(HTL2)=HOMO(HTL2). Die HOMO- und LUMO-Energieniveaus sind hierbei immer als negative Zahlen definiert. Eine analoge Definition gilt für die Energiedifferenz zwischen den anderen Schichten. Der Wert Max bezeichnet die maximal auftretende Energiedifferenz zwischen den verschiedenen Schichten.

Aus der Tabelle ist ersichtlich, dass die OLEDs V1 bis V6 alle einen hohen Wert Max aufweisen, also eine hohe Energiedifferenz (0.45 eV und mehr) zwischen benachbarten Lochtransportschichten bzw. der an die Emissionsschicht angrenzenden Lochtransportschicht und der Emissionsschicht. Die OLEDs E1 bis E7 hingegen weisen eine geringe Energiedifferenz (0.39 eV und weniger) zwischen benachbarten Lochtransportschichten bzw. der an die Emissionsschicht angrenzenden Lochtransportschicht und der Emissionsschicht auf.

Als emittierender Dotand in der Emissionsschicht wird die Verbindung D1 eingesetzt, die einen Unterschied zwischen $S_1$ und $T_1$-Energie von 0.09 eV aufweist.

Im Folgenden werden einige der Beispiele näher erläutert, um die Vorteile der erfindungsgemäßen OLEDs zu verdeutlichen. Es sei jedoch darauf hingewiesen, dass dies nur eine Auswahl der in Tabelle 3 gezeigten Daten darstellt.

Beispiel E3 zeigt, dass mit einer maximalen Energiedifferenz von 0.37 eV zwischen Lochtransportschichten und emittierender Schicht (Wert Max) etwa 30% bessere externe Quanteneffizienz und etwa 60% bessere Leistungseffizienz erreicht werden, als wenn die maximale Energiedifferenz 0.75 eV (Wert Max) beträgt, wie im Vergleichsbeispiel V4.

Der Vergleich zwischen den OLEDs E5 und V1, die sich nur in Bezug auf ihre Lochtransportschichten unterscheiden, zeigt eine überraschende Verbesserung der Lebensdauer um etwa 30% durch Verringerung der maximalen

Energiedifferenz (Wert Max) von 0.45 eV (Stand der Technik, V1) auf 0.32 eV (erfindungsgemäß, E5).

Der Effekt der Verbesserung der Leistungsdaten kann mit den verschiedensten Materialien für die Lochtransportschichten und den verschiedensten Materialien in der emittierenden Schicht erreicht werden, wie die Beispiele E1 bis E7 zeigen.

Tabelle 2: Aufbau der OLEDs

| Bsp | HTL1 Dicke | HTL2 Dicke | HTL3 Dicke | HTL4 Dicke | EML Dicke | HBL Dicke | ETL Dicke | EIL Dicke |
|---|---|---|---|---|---|---|---|---|
| V1 | --- | --- | --- | NPB 90nm | CBP:D1 (95%: 5%) 15nm | --- | ST2 50nm | LiQ 3nm |
| V2 | --- | --- | SpMA1:F4T (95%:5%) 10nm | SpMA1 80nm | IC1:D1 (95%: 5%) 15nm | IC1 10nm | ST2 40nm | LiQ 3nm |
| V3 | --- | --- | SpMA1:F4T (95%:5%) 10nm | SpMA1 80nm | BCP:D1 (95%: 5%) 15nm | IC1 10nm | ST2 40nm | LiQ 3nm |
| V4 | --- | --- | HAT 5nm | SpA1 85nm | IC3:D1 (95%: 5%) 15nm | IC1 10nm | ST2:LiQ (50%: 50%) 40nm | --- |
| V5 | --- | --- | --- | SpA1 90nm | IC4:D1 (95%: 5%) 15nm | IC1 10nm | ST2:LiQ (50%: 50%) 40nm | --- |
| V6 | --- | SpMA1:F4T (95%:5%) 10nm | SpMA1 75nm | IC1 5nm | BCP:D1 (95%: 5%) 15nm | IC1 10nm | ST2 40nm | LiQ 3nm |
| E1 | SpMA1:F4T (95%:5%) 10nm | SpMA1 65nm | SpMA2 10nm | IC2 5nm | IC1:D1 (95%: 5%) 15nm | IC1 10nm | ST2 40nm | LiQ 3nm |
| E2 | SpMA1:F4T (95%:5%) 10nm | SpMA1 65nm | IC2 10nm | CBP 5nm | IC1:D1 (95%: 5%) 15nm | IC1 10nm | ST2 40nm | LiQ 3nm |
| E3 | HAT 5nm | SpA1 70nm | HAT 5nm | SpMA1 10nm | IC3:D1 (95%: 5%) 15nm | IC1 10nm | ST2:LiQ (50%: 50%) 40nm | --- |
| E4 | --- | SpMA1:F4T (95%:5%) 10nm | SpMA1 70nm | IC2 10nm | CBP:D1 (95%: 5%) 15nm | IC1 10nm | ST2:LiQ (50%: 50%) 40nm | --- |
| E5 | --- | --- | NPB 80nm | SpMA2 10nm | CBP:D1 (95%: 5%) 15nm | --- | ST2 50nm | LiQ 3nm |

(fortgesetzt)

| Bsp | HTL1 Dicke | HTL2 Dicke | HTL3 Dicke | HTL4 Dicke | EML Dicke | HBL Dicke | ETL Dicke | EIL Dicke |
|---|---|---|---|---|---|---|---|---|
| E6 | --- | HAT 5nm | SpMA1 75nm | IC2 10nm | IC4:D1 (95%: 5%) 15nm | IC1 10nm | ST2:LiQ (50%: 50%) 40nm | --- |
| E7 | SpMA2:F4T (95%:5%) 10nm | SpMA2 70nm | CBP 5nm | IC1 5nm | BCP:D1 (95%: 5%) 15nm | IC1 10nm | ST2 40nm | LiQ 3nm |

Tabelle 3: Daten der OLEDs

| Bsp. | U1000 (V) | SE1000 (cd/A) | LE1000 (lm/W) | EQE1000 | CIE x/y bei 1000 cd/m$^2$ |
|---|---|---|---|---|---|
| V1 | 4.3 | 36 | 27 | 11.3% | 0.28/0.59 |
| V2 | 3.2 | 64 | 62 | 20.1% | 0.26/0.58 |
| V3 | 6.7 | 4.3 | 2.0 | 1.4% | 0.26/0.54 |
| V4 | 4.0 | 42 | 33 | 12.5% | 0.32/0.60 |
| V5 | 5.7 | 21 | 12 | 6.5% | 0.29/0.59 |
| V6 | 6.6 | 5.3 | 2.5 | 1.7% | 0.26/0.56 |
| E1 | 3.3 | 67 | 63 | 21.1% | 0.26/0.58 |
| E2 | 3.2 | 68 | 66 | 21.3% | 0.26/0.58 |
| E3 | 3.2 | 52 | 52 | 15.7% | 0.31/0.60 |
| E4 | 4.1 | 49 | 38 | 15.4% | 0.27/0.58 |
| E5 | 4.0 | 44 | 35 | 13.7% | 0.27/0.59 |
| E6 | 4.1 | 49 | 38 | 14.5% | 0.28/0.60 |
| E7 | 5.5 | 8.3 | 4.8 | 2.6% | 0.26/0.57 |

Tabelle 3: Daten der OLEDs (weiter)

| Bsp. | j0 | L1 % | LD (h) | PLQE % | $\lambda_{exc}$ nm | $t_d$ $\mu$s | $t_a$ $\mu$s |
|---|---|---|---|---|---|---|---|
| V1 | 10mA/cm$^2$ | 80 | 59 | 100 | 350 | 7 | 4.5 |
| V2 | 10mA/cm$^2$ | 80 | 30 | 92 | 350 | 7 | 5.4 |
| V3 | 10mA/cm$^2$ | 80 | 1 | 59 | 350 | 6 | 5.9 |
| V4 | 10mA/cm$^2$ | 80 | 82 | 77 | 350 | 7 | 7.0 |
| V5 | 10mA/cm$^2$ | 80 | 33 | 84 | 359 | 7 | 4.2 |
| V6 | 10mA/cm$^2$ | 80 | 1 | 59 | 350 | 6 | 5.9 |
| E1 | 10mA/cm$^2$ | 80 | 34 | 92 | 350 | 7 | 5.4 |
| E2 | 10mA/cm$^2$ | 80 | 38 | 92 | 350 | 7 | 5.4 |
| E3 | 10mA/cm$^2$ | 80 | 92 | 77 | 350 | 7 | 7.0 |
| E4 | 10mA/cm$^2$ | 80 | 37 | 100 | 350 | 7 | 4.5 |
| E5 | 10mA/cm$^2$ | 80 | 82 | 100 | 350 | 7 | 4.5 |

(fortgesetzt)

| Bsp. | j0 | L1 % | LD (h) | PLQE % | $\lambda_{exc}$ nm | $t_d$ μs | $t_a$ μs |
|---|---|---|---|---|---|---|---|
| E6 | 10mA/$cm^2$ | 80 | 48 | 84 | 359 | 7 | 4.2 |
| E7 | 10mA/$cm^2$ | 80 | 1 | 59 | 350 | 6 | 5.9 |

Tabelle 4: Strukturformeln der Materialien

| | |
|---|---|
| 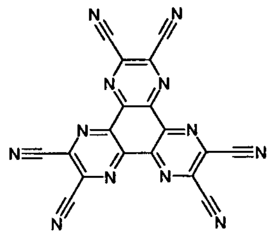 | 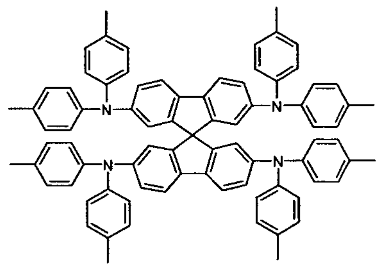 |
| HAT | SpA1 |
| 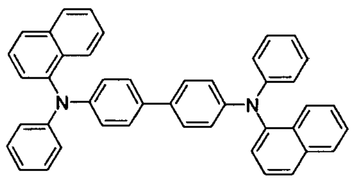 | 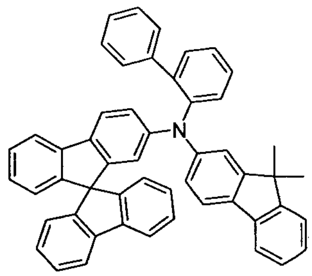 |
| NPB | SpMA1 |
| 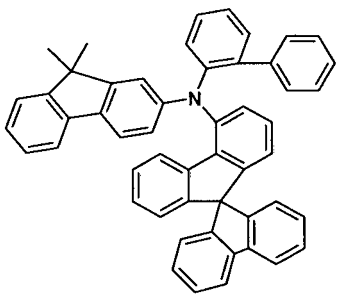 | 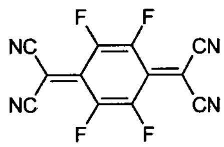 |
| SpMA2 | F4T |
| 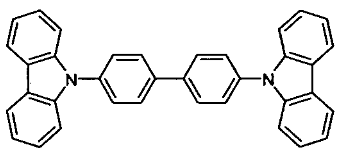 | 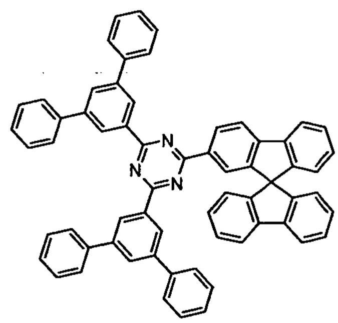 |
| CBP | ST2 |

(fortgesetzt)

| | |
|---|---|
| 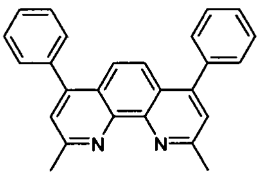 | 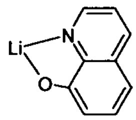 |
| BCP | LiQ |
| 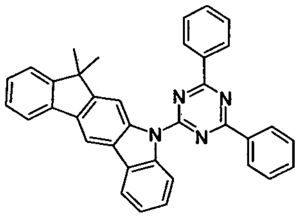 | 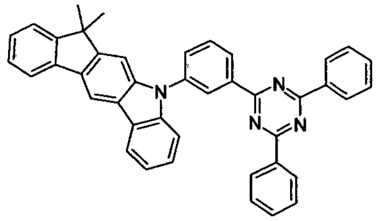 |
| IC1 | IC5 |
| 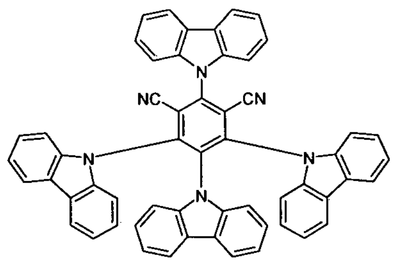 | 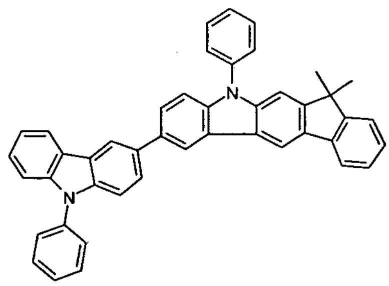 |
| D1 | IC2 |
| 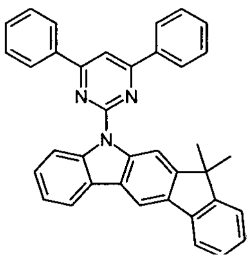 | 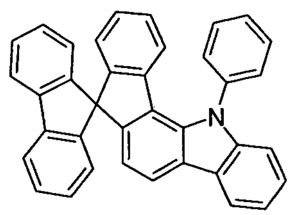 |
| IC3 | IC4 |

Tabelle 5: Energiedifferenzen zwischen den Schichten

| Bsp. | HTL1-HTL2 (eV) | HTL2-HTL3 (eV) | HTL3-HTL4 (eV) | HTL4-EML (eV) | Max (eV) |
|---|---|---|---|---|---|
| V1 | --- | --- | --- | 0.45 | 0.45 |
| V2 | --- | --- | 0 | 0.54 | 0.54 |
| V3 | --- | --- | 0 | 0.86 | 0.86 |
| V4 | --- | - | -0.06 | 0.75 | 0.75 |
| V5 | --- | --- | --- | 0.87 | 0.87 |
| V6 | --- | 0 | 0.54 | 0.32 | 0.54 |
| E1 | 0 | 0.1 | 0.05 | 0.39 | 0.39 |
| E2 | 0 | 0.15 | 0.27 | 0.12 | 0.27 |
| E3 | -0.06 | 0.06 | 0.32 | 0.37 | 0.37 |

(fortgesetzt)

| Bsp. | HTL1-HTL2 (eV) | HTL2-HTL3 (eV) | HTL3-HTL4 (eV) | HTL4-EML (eV) | Max (eV) |
|---|---|---|---|---|---|
| E4 | --- | 0 | 0.15 | 0.27 | 0.27 |
| E5 | --- | --- | 0.13 | 0.32 | 0.32 |
| E6 | --- | 0.32 | 0.15 | 0.34 | 0.34 |
| E7 | 0.1 | 0.32 | 0.12 | 0.32 | 0.32 |

**Patentansprüche**

**1.** Organische Elektrolumineszenzvorrichtung, enthaltend

- Anode,
- Kathode,
- mindestens eine emittierende Schicht, welche eine lumineszente organische Verbindung E enthält, die eine Differenz zwischen den Energien ihres $S_1$- und $T_1$-Zustands von nicht mehr als 0.15 eV aufweist, und
- 2, 3, 4 oder 5 zwischen Anoden-nächster emittierender Schicht EML und Anode angeordnete Schichten mit einer Dicke von jeweils mehr als 2 nm,

**dadurch gekennzeichnet, dass** für jede Schicht mit einer Dicke von mehr als 2 nm, die zwischen der Anode und der Schicht EML angeordnet ist, die folgende Bedingung gilt:

die Differenz D zwischen dem HOMO-Energieniveau der Schicht und dem HOMO-Energieniveau der kathodenseitig nächsten Schicht mit einer Dicke von mehr als 2 nm muss kleiner oder gleich 0.4 eV sein, mit der Maßgabe, dass für Schichten, deren HOMO-Energieniveau einen Wert von weniger als -6.7 eV aufweist, das LUMO-Energieniveau für die genannte Bedingung an die Stelle des HOMO-Energieniveaus tritt,
wobei HOMO- und LUMO-Energieniveaus und Energien von $S_1$- und $T_1$-Zuständen von Verbindungen gemäß dem in Abschnitt 1) der Ausführungsbeispiele beschriebenen Verfahren zu $T_1$-Zuständen von Verbindungen gemäß dem in Abschnitt 1) der bestimmen sind, und
wobei unter dem HOMO-Energieniveau einer Schicht, wenn die Schicht aus einer einzelnen Verbindung besteht, das HOMO-Energieniveau dieser Verbindung verstanden wird, und
wobei unter dem HOMO-Energieniveau einer Schicht, wenn die Schicht aus zwei oder mehr unterschiedlichen Verbindungen besteht, das HOMO-Energieniveau derjenigen der zwei oder mehr unterschiedlichen Verbindungen verstanden wird, die das höchstliegende HOMO-Energieniveau hat, und
wobei unter dem LUMO-Energieniveau einer Schicht, wenn die Schicht aus einer einzelnen Verbindung besteht, das LUMO-Energieniveau dieser Verbindung verstanden wird, und
wobei unter dem LUMO-Energieniveau einer Schicht, wenn die Schicht aus zwei oder mehr unterschiedlichen Verbindungen besteht, das LUMO-Energieniveau derjenigen der zwei oder mehr unterschiedlichen Verbindungen verstanden wird, die das tiefstliegende LUMO-Energieniveau hat.

**2.** Organische Elektrolumineszenzvorrichtung nach Anspruch 1, **dadurch gekennzeichnet, dass** für jede Schicht mit einer Dicke von mehr als 2 nm, die zwischen der Anode und der Schicht EML angeordnet ist, die folgende Bedingung gilt:

die Differenz D zwischen dem HOMO-Energieniveau der Schicht und dem HOMO-Energieniveau der kathodenseitig nächsten Schicht mit einer Dicke von mehr als 2 nm muss kleiner oder gleich 0.38 eV sein, bevorzugt kleiner oder gleich 0.35 eV, und besonders bevorzugt kleiner oder gleich 0.3 eV.

**3.** Organische Elektrolumineszenzvorrichtung nach Anspruch 1 oder 2, **dadurch gekennzeichnet, dass** sie genau eine emittierende Schicht umfasst.

**4.** Organische Elektrolumineszenzvorrichtung nach einem oder mehreren der Ansprüche 1 bis 3, **dadurch gekennzeichnet, dass** die Schichten der Vorrichtung eine Dicke von 4 bis 120 nm aufweisen.

**5.** Organische Elektrolumineszenzvorrichtung nach einem oder mehreren der Ansprüche 1 bis 4, **dadurch gekenn-**

**zeichnet, dass** die emittierende Schicht, welche die lumineszente organische Verbindung E enthält, die Anoden-nächste emittierende Schicht EML ist.

6. Organische Elektrolumineszenzvorrichtung nach einem oder mehreren der Ansprüche 1 bis 5, **dadurch gekennzeichnet, dass** die lumineszente Verbindung E eine Lumineszenzquanteneffizienz von mindestens 40 % aufweist, bevorzugt von mindestens 50 %, besonders bevorzugt von mindestens 60 % und ganz besonders bevorzugt von mindestens 70 %.

7. Organische Elektrolumineszenzvorrichtung nach einem oder mehreren der Ansprüche 1 bis 6, **dadurch gekennzeichnet, dass** die Verbindung E eine Differenz zwischen den Energien ihres $S_1$- und $T_1$-Zustands von nicht mehr als 0.10 eV aufweist, bevorzugt nicht mehr als 0.08 eV, und besonders bevorzugt nicht mehr als 0.05 eV.

8. Organische Elektrolumineszenzvorrichtung nach einem oder mehreren der Ansprüche 1 bis 7, **dadurch gekennzeichnet, dass** die emittierende Schicht, welche die Verbindung E enthält, zusätzlich ein oder mehrere Matrixmaterialien umfasst, und dass die Verbindung E die emittierende Verbindung ist.

9. Organische Elektrolumineszenzvorrichtung nach Anspruch 8, **dadurch gekennzeichnet, dass** die Energie des $T_1$-Zustands des Matrixmaterials der emittierenden Schicht höchstens um 0.1 eV niedriger ist als die Energie des $T_1$-Zustands der Verbindung E.

10. Organische Elektrolumineszenzvorrichtung nach einem oder mehreren der Ansprüche 1 bis 9, **dadurch gekennzeichnet, dass** die Energie des $T_1$-Zustands der direkt anodenseitig an die emittierende Schicht enthaltend die Verbindung E angrenzenden Schicht höchstens um 0.1 eV niedriger ist als die Energie des $T_1$-Zustands der Verbindung E.

11. Organische Elektrolumineszenzvorrichtung nach einem oder mehreren der Ansprüche 1 bis 10, **dadurch gekennzeichnet, dass** mindestens eine der zwischen der Schicht EML und der Anode angeordneten Schichten mindestens eine Triarylamino-Verbindung enthält, die nicht mehr als eine Aminogruppe aufweist.

12. Organische Elektrolumineszenzvorrichtung nach Anspruch 11, **dadurch gekennzeichnet, dass** die Triarylamino-Verbindung ein Molekulargewicht von weniger als 2000 Da aufweist, bevorzugt weniger als 1500 Da und besonders bevorzugt weniger als 1000 Da.

13. Organische Elektrolumineszenzvorrichtung nach einem oder mehreren der Ansprüche 1 bis 12, **dadurch gekennzeichnet, dass** eine oder mehrere der zwischen Anoden-nächster emittierender Schicht EML und Anode angeordneten Schichten einen Dotanden enthält, der eine Elektronenakzeptorverbindung ist.

14. Verfahren zur Herstellung einer organischen Elektrolumineszenzvorrichtung nach einem oder mehreren der Ansprüche 1 bis 13, **dadurch gekennzeichnet, dass** mindestens eine Schicht mit einem Sublimationsverfahren aufgebracht wird, oder dass mindestens eine Schicht mit einem OVPD (Organic Vapour Phase Deposition) Verfahren aufgebracht wird, oder dass mindestens eine Schicht mit Hilfe einer Trägergassublimation aufgebracht wird, oder dass mindestens eine Schicht aus Lösung aufgebracht wird.

## Claims

1. Organic electroluminescent device comprising

   - anode,
   - cathode,
   - at least one emitting layer which comprises a luminescent organic compound E which has a difference between the energies of its $S_1$ and $T_1$ states of not greater than 0.15 eV, and
   - 2, 3, 4 or 5 layers, each having a thickness of greater than 2 nm, arranged between the emitting layer EML closest to the anode and the anode,

   **characterised in that** the following condition applies to each layer having a thickness of greater than 2 nm which is arranged between the anode and the layer EML:

the difference D between the HOMO energy level of the layer and the HOMO energy level of the closest layer on the cathode side having a thickness of greater than 2 nm must be less than or equal to 0.4 eV, with the proviso that, for layers whose HOMO energy level has a value of less than -6.7 eV, the LUMO energy level for the said condition takes the place of the HOMO energy level,
where the HOMO and LUMO energy levels and the energies of the $S_1$ and $T_1$ states of compounds are to be determined by the method described in section 1) of the working examples (pp. 44-45), and
where the HOMO energy level of a layer, if the layer consists of a single compound, is taken to mean the HOMO energy level of this compound, and
where the HOMO energy level of a layer, if the layer consists of two or more different compounds, is taken to mean the HOMO energy level of the one of the two or more different compounds that has the highest HOMO energy level, and
where the LUMO energy level of a layer, if the layer consists of a single compound, is taken to mean the LUMO energy level of this compound, and
where the LUMO energy level of a layer, if the layer consists of two or more different compounds, is taken to mean the LUMO energy level of the one of the two or more different compounds that has the lowest LUMO energy level.

2. Organic electroluminescent device according to Claim 1, **characterised in that** the following condition applies to each layer having a thickness of greater than 2 nm which is arranged between the anode and the layer EML:

the difference D between the HOMO energy level of the layer and the HOMO energy level of the closest layer on the cathode side having a thickness of greater than 2 nm must be less than or equal to 0.38 eV, preferably less than or equal to 0.35 eV, and particularly preferably less than or equal to 0.3 eV.

3. Organic electroluminescent device according to Claim 1 or 2, **characterised in that** it comprises precisely one emitting layer.

4. Organic electroluminescent device according to one or more of Claims 1 to 3, **characterised in that** the layers of the device have a thickness of 4 to 120 nm.

5. Organic electroluminescent device according to one or more of Claims 1 to 4, **characterised in that** the emitting layer which comprises the luminescent organic compound E is the emitting layer EML closest to the anode.

6. Organic electroluminescent device according to one or more of Claims 1 to 5, **characterised in that** the luminescent compound E has a luminescence quantum efficiency of at least 40%, preferably at least 50%, particularly preferably at least 60% and very particularly preferably at least 70%.

7. Organic electroluminescent device according to one or more of Claims 1 to 6, **characterised in that** compound E has a difference between the energies of its $S_1$ and $T_1$ states of not greater than 0.10 eV, preferably not greater than 0.08 eV, and particularly preferably not greater than 0.05 eV.

8. Organic electroluminescent device according to one or more of Claims 1 to 7, **characterised in that** the emitting layer which comprises compound E additionally comprises one or more matrix materials, and **in that** compound E is the emitting compound.

9. Organic electroluminescent device according to Claim 8, **characterised in that** the energy of the $T_1$ state of the matrix material of the emitting layer is at most 0.1 eV lower than the energy of the $T_1$ state of compound E.

10. Organic electroluminescent device according to one or more of Claims 1 to 9, **characterised in that** the energy of the $T_1$ state of the layer directly adjacent to the emitting layer comprising compound E on the anode side is at most 0.1 eV lower than the energy of the $T_1$ state of compound E.

11. Organic electroluminescent device according to one or more of Claims 1 to 10, **characterised in that** at least one of the layers arranged between the layer EML and the anode comprises at least one triarylamino compound which has not more than one amino group.

12. Organic electroluminescent device according to Claim 11, **characterised in that** the triarylamino compound has a molecular weight of less than 2000 Da, preferably less than 1500 Da and particularly preferably less than 1000 Da.

**13.** Organic electroluminescent device according to one or more of Claims 1 to 12, **characterised in that** one or more of the layers arranged between the emitting layer EML closest to the anode and the anode comprises a dopant which is an electron-acceptor compound.

**14.** Process for the production of an organic electroluminescent device according to one or more of Claims 1 to 13, **characterised in that** at least one layer is applied by means of a sublimation process, or **in that** at least one layer is applied by means of an OVPD (organic vapour phase deposition) process, or **in that** at least one layer is applied with the aid of carrier-gas sublimation, or **in that** at least one layer is applied from solution.

**Revendications**

**1.** Dispositif électroluminescent organique comprenant :

- une anode,
- une cathode,
- au moins une couche d'émission qui comprend un composé organique luminescent E qui présente une différence entre les énergies de ses états $S_1$ et $T_1$ non supérieure à 0,15 eV, et
- 2, 3, 4 ou 5 couches, dont chacune présente une épaisseur supérieure à 2 nm, lesquelles couches sont agencées entre la couche d'émission EML la plus proche de l'anode et l'anode,

**caractérisé en ce que** la condition qui suit s'applique à chaque couche présentant une épaisseur supérieure à 2 nm qui est agencée entre l'anode et la couche EML :

la différence D entre le niveau d'énergie HOMO de la couche et le niveau d'énergie HOMO de la couche la plus proche sur le côté de la cathode présentant une épaisseur supérieure à 2 nm doit être inférieure ou égale à 0,4 eV, étant entendu que, pour des couches dont le niveau d'énergie HOMO présente une valeur inférieure à -6,7 eV, le niveau d'énergie LUMO pour ladite condition prend la place du niveau d'énergie HOMO,
dans lequel les niveaux d'énergie HOMO et LUMO et les énergies des états $S_1$ et $T_1$ de composés doivent être déterminés au moyen du procédé qui est décrit dans la section 1) des exemples concrets (pp. 44-45), et
dans lequel le niveau d'énergie HOMO d'une couche, si la couche est constituée par un unique composé, est considéré comme signifiant le niveau d'énergie HOMO de ce composé, et
dans lequel le niveau d'énergie HOMO d'une couche, si la couche est constituée par deux composés différents ou plus, est considéré comme signifiant le niveau d'énergie HOMO de celui des deux composés différents ou plus qui présente le niveau d'énergie HOMO le plus élevé, et
dans lequel le niveau d'énergie LUMO d'une couche, si la couche est constituée par un unique composé, est considéré comme signifiant le niveau d'énergie LUMO de ce composé, et
dans lequel le niveau d'énergie LUMO d'une couche, si la couche est constituée par deux composés différents ou plus, est considéré comme signifiant le niveau d'énergie LUMO de celui des deux composés différents ou plus qui présente le niveau d'énergie LUMO le plus bas.

**2.** Dispositif électroluminescent organique selon la revendication 1, **caractérisé en ce que** la condition qui suit s'applique à chaque couche présentant une épaisseur supérieure à 2 nm qui est agencée entre l'anode et la couche EML :

la différence D entre le niveau d'énergie HOMO de la couche et le niveau d'énergie HOMO de la couche la plus proche sur le côté de la cathode présentant une épaisseur supérieure à 2 nm doit être inférieure ou égale à 0,38 eV, de préférence inférieure ou égale à 0,35 eV, et de façon particulièrement préférable inférieure ou égale à 0,3 eV.

**3.** Dispositif électroluminescent organique selon la revendication 1 ou 2, **caractérisé en ce qu'**il comprend précisément une couche d'émission.

**4.** Dispositif électroluminescent organique selon une ou plusieurs des revendications 1 à 3, **caractérisé en ce que** les couches du dispositif présentent une épaisseur de 4 à 120 nm.

**5.** Dispositif électroluminescent organique selon une ou plusieurs des revendications 1 à 4, **caractérisé en ce que** la couche d'émission qui comprend le composé organique luminescent E est la couche d'émission EML la plus proche de l'anode.

**6.** Dispositif électroluminescent organique selon une ou plusieurs des revendications 1 à 5, **caractérisé en ce que** le composé luminescent E présente un rendement quantique de luminescence d'au moins 40%, de préférence d'au moins 50%, de façon particulièrement préférable d'au moins 60% et de façon très particulièrement préférable d'au moins 70%.

**7.** Dispositif électroluminescent organique selon une ou plusieurs des revendications 1 à 6, **caractérisé en ce que** le composé luminescent E présente une différence entre les énergies de ses états $S_1$ et $T_1$ non supérieure à 0,10 eV, de préférence non supérieure à 0,08 eV, et de façon particulièrement préférable non supérieure à 0,05 eV.

**8.** Dispositif électroluminescent organique selon une ou plusieurs des revendications 1 à 7, **caractérisé en ce que** la couche d'émission, laquelle couche comprend le composé luminescent E, comprend de façon additionnelle un ou plusieurs matériau(x) de matrice, et **en ce que** le composé luminescent E est le composé d'émission.

**9.** Dispositif électroluminescent organique selon la revendication 8, **caractérisé en ce que** l'énergie de l'état $T_1$ du matériau de matrice de la couche d'émission est d'au plus de 0,1 eV inférieur à l'énergie de l'état $T_1$ du composé luminescent E.

**10.** Dispositif électroluminescent organique selon une ou plusieurs des revendications 1 à 9, **caractérisé en ce que** l'énergie de l'état $T_1$ de la couche qui est directement adjacente à la couche d'émission qui comprend le composé luminescent E sur le côté de l'anode est d'au plus de 0,1 eV inférieur à l'énergie de l'état $T_1$ du composé luminescent E.

**11.** Dispositif électroluminescent organique selon une ou plusieurs des revendications 1 à 10, **caractérisé en ce qu'**au moins l'une des couches qui sont agencées entre la couche EML et l'anode comprend au moins un composé triarylamino qui ne comporte pas plus d'un groupe amino.

**12.** Dispositif électroluminescent organique selon la revendication 11, **caractérisé en ce que** le composé triarylamino présente un poids moléculaire inférieur à 2000 Da, de préférence inférieur à 1500 Da et de façon particulièrement préférable inférieur à 1000 Da.

**13.** Dispositif électroluminescent organique selon une ou plusieurs des revendications 1 à 12, **caractérisé en ce qu'**une ou plusieurs des couches qui sont agencées entre la couche d'émission EML la plus proche de l'anode et l'anode comprend/comprennent un dopant qui est un composé accepteur d'électrons.

**14.** Procédé pour la production d'un dispositif électroluminescent organique selon une ou plusieurs des revendications 1 à 13, **caractérisé en ce qu'**au moins une couche est appliquée au moyen d'un procédé de sublimation, ou **en ce qu'**au moins une couche est appliquée au moyen d'un procédé OVPD (dépôt organique en phase vapeur), ou **en ce qu'**au moins une couche est appliquée à l'aide d'une sublimation par gaz porteur, ou **en ce qu'**au moins une couche est appliquée à partir d'une solution.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- WO 2004013080 A
- WO 2004093207 A
- WO 2006005627 A
- WO 2010006680 A
- WO 2005039246 A
- US 20050069729 A
- JP 2004288381 A
- EP 1205527 A
- WO 2008086851 A
- US 20090134784 A
- WO 2007063754 A
- WO 2008056746 A
- WO 2010136109 A
- WO 2011000455 A
- EP 1617710 A
- EP 1617711 A
- EP 1731584 A
- JP 2005347160 A
- WO 2007137725 A
- WO 2005111172 A
- WO 2006117052 A
- WO 2010054729 A
- WO 2010054730 A
- WO 2010015306 A
- EP 652273 A
- WO 2009062578 A
- US 20090136779 A
- WO 2010050778 A
- WO 2011042107 A
- WO 2011088877 A
- JP 2000053957 A
- WO 2003060956 A
- WO 2004028217 A
- WO 2004080975 A
- WO 2010072300 A


### In der Beschreibung aufgeführte Nicht-Patentliteratur


- **H. UOYAMA et al.** *Nature,* 2012, vol. 492, 234
- **MEHES et al.** *Angew. Chem. Int. Ed.,* 2012, vol. 51, 11311
- **ENDO et al.** *Appl. Phys. Lett.,* 2011, vol. 98, 083302
- **NAKAGAWA et al.** *Chem. Commun.,* 2012, vol. 48, 9580
- **TANAKA et al.** *Chem. Comm.,* 2012, 11392
- **LEE et al.** *Appl. Phys. Lett.,* 2012, vol. 101 (093306), 1
- **T. MATSUMOTO ; T. NAKADA ; J. ENDO ; K. MORI ; N. KAWAMURA ; A. YOKOI ; J. KIDO.** *Multiphoton Organic EL Device Having Charge Generation Layer*
- **M. S. ARNOLD et al.** *Appl. Phys. Lett.,* 2008, vol. 92, 053301
- **H. UOYAMA et al.** *Nature,* 2012, vol. 492 (7428), 234-238
- **K. MASUI et al.** *Organic Electronics,* 2013, vol. 14 (11), 2721-2726